# FASCICULE DE BREVET EUROPEEN

(11) **EP 3 206 079 B1**
(45) Date de publication et mention de la délivrance du brevet: **11.07.2018**
(21) Numéro de dépôt: 17153847.3
(22) Date de dépôt: 30.01.2017
(51) Int. Cl.: G02F 1/025, G02B 6/42, H01S 5/026, H01S 5/02

(54) **TRANSMETTEUR PHOTONIQUE**
PHOTONISCHER SENDER
PHOTONIC TRANSMITTER

(30) Priorité: 12.02.2016 FR 1651138
(43) Date de publication de la demande: 16.08.2017
(73) Titulaire: Commissariat à l'énergie atomique et aux énergies alternatives, 75015 Paris (FR)
(72) Inventeur: MENEZO, Sylvie, 38500 Voiron (FR)
(74) Mandataire: Colombo, Michel

(56) Documents cités:
- US-A1- 2015 055 910
- US-A1- 2015 380 900
- MARTIJN J R HECK ET AL: "Hybrid Silicon Photonic Integrated Circuit Technology", IEEE JOURNAL OF SELECTED TOPICS IN QUANTUM ELECTRONICS, IEEE SERVICE CENTER, PISCATAWAY, NJ, US, vol. 19, no. 4, 1 juillet 2013 (2013-07-01), page 6100117, XP011508623, ISSN: 1077-260X, DOI: 10.1109/JSTQE.2012.2235413
- B. BEN BAKIR ET AL: "(Invited) Heterogeneously Integrated III-V on Silicon Lasers", ECS TRANSACTIONS, vol. 64, no. 5, 14 août 2014 (2014-08-14), pages 211-223, XP55382313, US ISSN: 1938-6737, DOI: 10.1149/06405.0211ecst

## Description

L'invention concerne un transmetteur photonique comportant une source laser et un modulateur. L'invention a également pour objet un procédé de fabrication de ce transmetteur.

Par perte de propagation, on désigne les pertes optiques vues par le mode optique se propageant dans un guide d'onde dans lequel il est guidé.

Par indice de propagation, on désigne l'indice effectif de propagation du mode optique se propageant dans un guide d'onde dans lequel il est guidé.

Des transmetteurs photoniques connus comportent :
- un empilement comportant un substrat s'étendant principalement dans un plan appelé « plan du substrat » et une couche, comportant du silicium monocristallin, s'étendant directement sur ce substrat et principalement parallèlement au plan du substrat,
- une source laser à semi-conducteur apte à générer un signal optique, cette source laser comportant un premier guide d'onde en matériau III-V gravé dans une couche en matériau à gain III-V, cette couche en matériau à gain III-V comportant une sous-couche en matériau cristallin III-V dopé,
- un modulateur des pertes de propagation et de l'indice de propagation d'un signal optique guidé réalisé sur le même substrat et apte à moduler le signal optique généré par la source laser à semi-conducteur, ce modulateur comportant :
   - une première électrode en silicium monocristallin dopé P ou N structurée dans le silicium monocristallin de la couche comportant du silicium monocristallin,
   - une seconde électrode en matériau cristallin III-V dopé présentant un dopage de signe opposé à celui de la première électrode,

Un tel transmetteur est par exemple divulgué dans la demande US2015/380900A1.

Par ailleurs, des modulateurs connus comportent un guide d'onde formé par l'empilement immédiatement les uns sur les autres :
- d'une extrémité proximale d'une première électrode en silicium monocristallin,
- d'une fine couche en matériau diélectrique, et
- d'une extrémité proximale d'une seconde électrode.

Par exemple, un tel modulateur est décrit dans la demande US2009103850.

En appliquant une différence de potentiels entre les première et seconde électrodes, la densité de porteurs de charges au niveau des interfaces entre la couche en matériau diélectrique et les extrémités proximales des première et seconde électrodes est modifiée. Cela induit une modification des pertes de propagation et de l'indice de propagation vus par le champ optique guidé et se propageant dans le guide d'onde. Typiquement, la couche en matériau diélectrique est une couche en dioxyde de silicium. Il est très difficile de faire croître par épitaxie une couche de silicium monocristallin sur une telle couche en dioxyde de silicium. Dès lors, il a été proposé de réaliser la seconde électrode en silicium amorphe ou polycristallin. Toutefois, l'utilisation d'une électrode en silicium amorphe ou polycristallin augmente les pertes optiques du champ, ce qui n'est pas souhaitable.

Pour remédier à cet inconvénient, la demande WO2011/037686 propose un procédé de fabrication qui permet de réaliser la seconde électrode du modulateur en silicium monocristallin, par collage d'une couche en silicium monocristallin

La demande US2015/0055910 propose quant à elle de réaliser la seconde électrode en matériau cristallin III-V tel que de l'InP, par collage direct sur le silicium d'une couche en matériau cristallin III-V. L'utilisation d'un matériau cristallin III-V pour réaliser la seconde électrode doit limiter les pertes optiques par rapport au cas où elle est réalisée en silicium amorphe ou polycristallin.

Plus précisément, le modulateur décrit en référence à la figure 2 de la demande US2015/0055910 comprend :
- un substrat s'étendant principalement dans un plan appelé « plan du substrat » et une couche, comportant du silicium monocristallin, s'étendant directement sur ce substrat et principalement parallèlement au plan du substrat,
- une première électrode en silicium monocristallin dopé P ou N structurée dans le silicium monocristallin de la couche comportant du silicium monocristallin, cette première électrode s'étendant, dans une direction transversale parallèle au plan du substrat, depuis une extrémité proximale jusqu'à une extrémité distale, et s'étendant longitudinalement dans la direction de propagation du signal optique,
- une seconde électrode en matériau cristallin III-V dopé présentant un dopage de signe opposé à celui de la première électrode, cette seconde électrode s'étendant, dans la direction transversale, depuis une extrémité proximale située en vis-à-vis de l'extrémité proximale de la première électrode jusqu'à une extrémité distale située d'un côté opposé à l'extrémité distale de la première électrode par rapport à un axe perpendiculaire au plan du substrat et traversant les extrémités proximales, cette seconde électrode s'étendant longitudinalement également dans la direction de propagation du signal optique,
- une couche en matériau diélectrique interposée entre les extrémités proximales des première et seconde électrodes pour les isoler électriquement l'une de l'autre,
- un premier guide d'onde apte à guider le signal optique à moduler dans la direction de propagation du signal optique, ce premier guide d'onde étant formé par les extrémités proximales des électrodes et la portion de la couche en matériau diélectrique interposée entre ces extrémités proximales,
- des prises de contact directement en contact mécanique et électrique avec, respectivement, les extrémités distales des électrodes pour raccorder électriquement les première et seconde électrodes à des potentiels électriques différents de manière à modifier la densité de porteurs de charges à l'intérieur du premier guide d'onde,
- une zone qui s'étend :
   - dans la direction perpendiculaire au plan du substrat, depuis l'extrémité distale de la seconde électrode jusqu'au substrat, et
   - dans la direction transversale et dans la direction de propagation du signal optique, sous la totalité de l'extrémité distale de la seconde électrode.

Dans la demande US2015/0055910, la zone qui s'étend sous l'extrémité distale de la seconde électrode jusqu'au substrat sur lequel est déposée la couche de silicium monocristallin comporte un bloc (référence 116 sur la figure 2 de la demande US2015/0055910) en silicium monocristallin isolé du guide d'onde par un bloc d'air (référence 112 sur la figure 2 de la demande US2015/0055910).

Par construction, dans le modulateur de la demande US2015/0055910 ou WO2011/037686 ou US2009103850, l'épaisseur de silicium monocristallin constituant l'extrémité proximale de la première électrode du modulateur doit être égale à l'épaisseur totale du silicium monocristallin déposé sur le substrat.

De l'état de la technique est également connu de : US6845198B2, US2015/277159A1, US2015/380900A1 et de l'article suivant :
- Martijn J R Heck et Al : « Hybrid Silicon Photonic Integrated Circuit Technology », IEEE Journal of selected topics in quantum electronics, IEEE Service Center, NJ, US, vol. 19, n°4, 1/7/2013, page 6100117.

L'invention décrite ici vise à proposer un transmetteur dont les performances sont améliorées tout en restant simple à fabriquer.

Elle a donc pour objet un tel transmetteur conforme à la revendication 1.

Dans le transmetteur revendiqué, le modulateur conserve l'avantage de pertes réduites du modulateur de la demande US2015/0055910. En effet, l'une des électrodes est en silicium monocristallin tandis que l'autre électrode est en matériau cristallin III-V.

De plus, le modulateur revendiqué ne présente aucune capacité parasite par rapport au modulateur de la demande US2015/0055910, ce qui permet d'obtenir une vitesse de modulation bien plus rapide que celle du modulateur de la demande US2015/0055910. Plus précisément, il a été découvert que l'extrémité distale de la seconde électrode (référence 104 sur la figure 2 de US2015/0055910) du modulateur de la demande US2015/0055910 forme avec la couche en matériau diélectrique (référence 118 sur la figure 2 de la demande US2015/0055910) et un bloc (référence 116 sur la figure 2 de la demande US2015/0055910) de la couche en silicium monocristallin, une capacité parasite qui réduit fortement la vitesse de modulation du modulateur de la demande US2015/0055910. A l'inverse, dans le modulateur revendiqué, la zone située sous l'extrémité distale de la seconde électrode est uniquement formée d'un matériau diélectrique de sorte que la capacité du condensateur parasite à cet endroit est fortement réduite.

De façon générale, le fait que la première électrode soit encapsulée dans le matériau diélectrique facilite également la fabrication de ce modulateur. Par exemple, les marges d'erreur sur l'alignement des électrodes l'une en face de l'autre peuvent être assez importante car cette erreur d'alignement ne crée pas de capacité parasite importante dans le cas du modulateur revendiqué.

Les modes de réalisation de ce transmetteur peuvent comporter une ou plusieurs des caractéristiques des revendications dépendantes.

Ces modes de réalisation du transmetteur présentent en outre les avantages suivants :
- Le fait que la seconde électrode soit réalisée dans la même sous-couche en matériau cristallin III-V que celle utilisée pour la réalisation du guide d'onde en matériau III-V de la source laser, simplifie grandement la fabrication du transmetteur.
- Le fait que l'épaisseur de l'extrémité proximale de la première électrode soit différente de l'épaisseur du guide d'onde en silicium monocristallin situé sous le guide d'onde en matériau III-V de la source laser permet d'améliorer à la fois le fonctionnement de la source laser et du modulateur. En effet, pour améliorer le fonctionnement de la source laser, il est souhaitable que l'épaisseur du guide d'onde situé sous le guide d'onde en matériau III-V de cette source laser soit importante. A l'inverse, pour améliorer le fonctionnement du modulateur, il est souhaitable que l'épaisseur de l'extrémité proximale de la première électrode soit environ égale à l'épaisseur de l'extrémité proximale de la seconde électrode. Or l'épaisseur de l'extrémité proximale de la seconde électrode est généralement plus petite que l'épaisseur de guide d'onde situé sous le guide d'onde en matériau III-V.
- Le fait que l'épaisseur maximale de l'extrémité proximale de la première électrode soit strictement inférieure à l'épaisseur maximale du deuxième guide d'onde, permet de rapprocher, de la couche en matériau diélectrique, le point où se situe le maximum de l'intensité du champ optique qui se propage dans le guide d'onde. En faisant cela, on rapproche ce point de la zone où la densité des porteurs de charge est maximale lorsqu'une différence de potentiels est appliquée entre les prises de contact de ce modulateur. Cela améliore l'efficacité de ce modulateur.

- De façon similaire, choisir l'épaisseur maximale de l'extrémité proximale de la première électrode proche de l'épaisseur maximale de l'extrémité proximale de la seconde électrode, améliore l'efficacité du modulateur, en particulier, si les matériaux ont à peu près les mêmes indices de réfraction, ce qui est le cas, par exemple, pour l'InP et silicium ou l'AsGa et le silicium. Par exemple, des indices n₁ et n₂ de réfraction sont considérés comme étant à peu près les mêmes si l'indice n₁ est compris dans l'intervalle [0,7n₂ ; 1,3n₂] et, de préférence, dans l'intervalle [0,85n₂ ; 1,15n₂] ou [0,95n₂ ; 1,05n₂].
- La présence d'une partie intermédiaire amincie dans l'électrode limite les conséquences des erreurs d'alignement lors de la fabrication du transmetteur et permet donc d'obtenir un modulateur dans lequel les capacités parasites sont réduites.
- L'utilisation d'un dispositif d'accord de phase comportant un bras en silicium dont une extrémité distale forme une résistance électrique constituée en silicium dopé et dont l'extrémité proximale est directement en contact mécanique avec un guide d'onde en silicium, permet de chauffer efficacement ce guide d'onde tout en limitant les pertes de propagation dans ce guide d'onde. En effet, dans ce dispositif d'accord, la résistance électrique est éloignée du guide d'onde et n'augmente donc pas les pertes de propagation dans ce guide d'onde. Ainsi, ce dispositif d'accord est avantageux par rapport aux dispositifs d'accord connus comportant une résistance électrique obtenue par dopage d'une région du guide d'onde ou par réalisation d'une résistance électrique à proximité immédiate du guide d'onde. En effet, dans ces deux derniers cas, la résistance électrique se situe à l'intérieur d'une zone où l'intensité du champ optique du signal optique qui se propage est importante, ce qui induit des pertes de propagation importantes.

L'invention a également pour objet un procédé de fabrication du transmetteur revendiqué.

Dans le procédé de fabrication revendiqué, l'épaisseur de silicium monocristallin peut être ajustée à souhait et, notamment, en fonction de l'épaisseur de la deuxième électrode. Ainsi, il est possible de placer le maximum d'intensité du champ optique guidé au niveau de l'interface de la couche en matériau diélectrique où la variation de densité des porteurs de charges est maximale. Ceci n'est pas possible avec les procédés de fabrication des modulateurs des demandes US2015/0055910, WO2011/037686 et US2009103850. En effet, dans ces demandes de brevet, l'épaisseur de silicium monocristallin constituant l'extrémité proximale de la première électrode doit être égale à l'épaisseur maximale de la couche en silicium monocristallin. Elle ne peut pas être réduite uniquement au niveau de l'extrémité proximale de la première électrode. Or, dans le cas d'un transmetteur comportant un guide d'onde réalisé dans cette couche en silicium, c'est l'épaisseur maximale de ce guide d'onde qui impose l'épaisseur de la couche en silicium. L'épaisseur de l'extrémité proximale de la première électrode ne peut donc pas être librement ajustée dans les procédés connus de fabrication d'un transmetteur. De plus, le procédé revendiqué permet aussi de limiter l'erreur sur la largeur de l'extrémité proximale de la première électrode du modulateur. En effet dans la demande US2015/0055910, le côté gauche de l'extrémité proximale de l'électrode en silicium est réalisé lors d'une première étape de gravure puis le côté droit de cette extrémité proximale est réalisé lors d'une deuxième étape de gravure. Si lors de chaque étape de gravure, l'erreur d'alignement est de +/- 100 nm, l'erreur sur la largeur W de cette extrémité proximale dans le modulateur de US2015/0055910 est alors de +/- 200nm. A l'inverse, le procédé revendiqué permet de gravé simultanément les côtés droit et gauche de l'extrémité proximale de la première électrode. Par conséquent, l'erreur sur la largeur W de l'extrémité proximale de la première électrode est uniquement de +/-100nm avec le procédé revendiqué.

Des modes de réalisation du procédé de fabrication présentent en outre les avantages suivants :
- L'utilisation d'une couche enterrée en matériau diélectrique dont l'épaisseur est inférieure à 100 nm ou 70 nm permet de limiter la quantité de matière à enlever pour obtenir l'épaisseur souhaitée de cette couche. Grâce à cela, la couche d'épaisseur souhaitée obtenue est plus plane ce qui améliore les performances du modulateur et de la source laser.
- Fabriquer en même temps la seconde électrode du modulateur et une partie de la source laser, simplifie la fabrication du transmetteur.

L'invention sera mieux comprise à la lecture de la description qui va suivre, donnée uniquement à titre d'exemple non limitatif et faite en se référant aux dessins sur lesquels :
- la figure 1 est une illustration schématique d'un transmetteur en coupe verticale ;
- la figure 2 est une illustration schématique, en vue de dessus, d'un modulateur et d'un dispositif d'accord de phase du transmetteur de la figure 1 ;
- la figure 3 est un organigramme d'un procédé de fabrication du transmetteur de la figure 1 ;
- les figures 4 à 15 sont des illustrations schématiques, en coupe verticale, de différents états de fabrication obtenus lors de la mise en oeuvre du procédé de la figure 3 ;
- les figures 16 à 19 sont des illustrations schématiques, en coupe verticale, d'autres modes de réalisation possibles du transmetteur de la figure 1 ;
- la figure 20 est un organigramme partiel d'un procédé de fabrication du transmetteur de la figure 19 ;
- les figures 21 à 24 sont des illustrations schématiques, en coupe verticale, de différents états de fabrication obtenus lors de la mise en oeuvre du procédé de la figure 20 ;
- la figure 25 est une illustration schématique d'un procédé de fabrication du transmetteur de la figure 18, et
- les figures 26 à 31 sont des illustrations schématiques, en coupe verticale, de différents états de fabrication obtenus lors de la mise en oeuvre du procédé de la figure 25.

Dans ces figures, les mêmes références sont utilisées pour désigner les mêmes éléments. Dans la suite de cette description, les caractéristiques et fonctions bien connues de l'homme du métier ne sont pas décrites en détail.

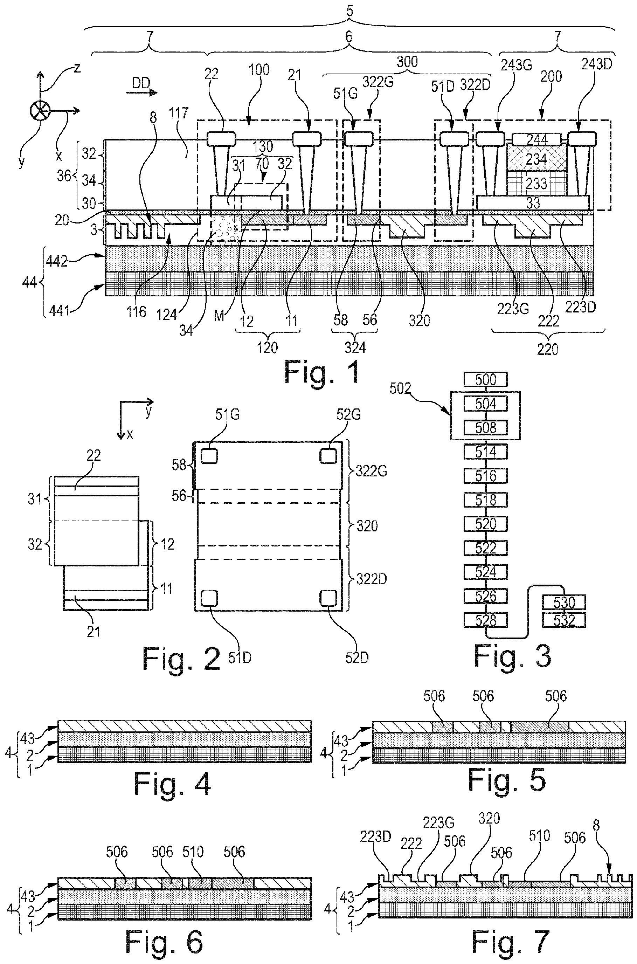

La figure 1 représente un transmetteur 5 d'un signal optique modulé en phase et/ou en amplitude pour transmettre des bits d'informations vers un récepteur par l'intermédiaire d'une fibre optique par exemple. A cet effet, le transmetteur 5 comporte une source laser 7 qui émet un signal optique dont la phase et/ou l'amplitude est ensuite modulée par un système 6 de modulation de phase et/ou d'amplitude de ce signal optique.

Par exemple, la longueur d'onde λ_{Li} du signal optique émis par la source laser 7 est comprise entre 1250 nm et 1590 nm.

Le système 6 peut être un système de modulation de la phase seule, ou de l'amplitude seule ou simultanément de la phase et de l'amplitude.

Typiquement, la source laser 7 peut être un laser DBR (« distributed bragg reflector laser ») ou DFB (« distributed feedback laser »). Une telle source laser est bien connue et seuls les détails nécessaires pour la compréhension de l'invention sont décrits ici. Par exemple, pour des détails généraux et le fonctionnement d'une telle source laser, le lecteur peut se référer aux articles suivants :
- B. Ben Bakir et al., « Hybrid Si/III-V lasers with adiabatic coupling », 2011.
- B. Ben Bakir, C. Sciancalepore, A. Descos, H. Duprez, D. Bordel, L. Sanchez, C. Jany, K. Hassan, P. Brianceau, V. Carron, and S. Menezo, « Heterogeneously Integrated III-V on Silicon Lasers », Invited Talk ECS 2014.

Pour simplifier la figure 1 et les figures suivantes, seul un guide d'onde laser hybride 200, 220 et un coupleur surfacique 8 (connu sous le terme anglais de « Surface grating coupler ») de la source laser 7 sont représentés.

Un tel coupleur 8 est par exemple décrit dans l'article suivant : F. Van Laere, G. Roelkens, J. Schrauwen, D. Taillaert, P. Dumon, W. Bogaerts, D. Van Thourhout and R. Baets, « Compact grating couplers between optical fibers and Silicon-on-Insulator photonic wire waveguides with 69% coupling efficiency*".* Il est réalisé dans une couche 3 comportant du silicium monocristallin encapsulé dans un matériau diélectrique 116. Généralement, un matériau diélectrique a une conductivité électrique à 20 °C inférieure à 10⁻⁷S/M et, de préférence, inférieure à 10⁻⁹S/m ou 10⁻¹⁵S/m. De plus, dans le cas du matériau diélectrique 116, son indice de réfraction est strictement inférieur à l'indice de réfraction du silicium. Par exemple, dans ce mode de réalisation, le matériau diélectrique 116 est du dioxyde de silicium (SiO₂).

La couche 3 s'étend principalement horizontalement et directement sur un substrat rigide 44. Dans la couche 3, le silicium monocristallin est situé dans un même plan horizontal parallèle au plan du substrat 44. Ici, le silicium monocristallin de la couche 3 est également isolé mécaniquement et électriquement du substrat 44 par le matériau diélectrique 116.

Sur la figure 1 et les figures suivantes, l'horizontal est représenté par des directions X et Y d'un repère orthogonal. La direction Z de ce repère orthogonal représente la direction verticale. Par la suite, les termes tels que « supérieur », « inférieur », « au-dessus », « en dessous », « haut » et « bas » sont définis par rapport à cette direction Z. Les termes « gauche » et « droite » sont définis par rapport à la direction X. Les termes « avant » et « arrière » sont définis par rapport à la direction Y.

La figure 1 représente les éléments du transmetteur 5 en coupe dans un plan vertical parallèle aux directions X et Z.

Par exemple, l'épaisseur maximale de silicium monocristallin dans la couche 3 est comprise entre 100 nm et 800 nm. Dans cet exemple, l'épaisseur maximale du silicium monocristallin dans la couche 3 est égale à 300 nm ou 500 nm.

Le substrat 44 s'étend horizontalement. Dans cet exemple de réalisation, le substrat 44 est formé d'un empilement successif d'un support 441 et d'une couche 442 en matériau diélectrique. L'épaisseur du support 441 est typiquement supérieure à 200 µm ou 400 µm. Par exemple, le support 441 est un support en silicium. La couche 442 est en dioxyde de silicium. L'épaisseur de la couche 442 est typiquement supérieure à 500 nm ou 1 µm voire plus.

Le guide d'onde laser hybride 200, 220 est constitué d'un guide d'onde 200 réalisé dans matériau a gain III-V et d'un guide d'onde 220 en silicium monocristallin. Généralement le guide d'onde 200 est utilisé pour générer et amplifier un signal optique à l'intérieur d'une cavité optique de la source laser 7. Ici, à cet effet, il est réalisé dans une couche 36 comportant un matériau à gain III-V encapsulé dans un matériau diélectrique 117. Par exemple, le matériau 117 est du dioxyde de silicium ou du nitrure de silicium. Cette couche 36 s'étend horizontalement directement sur une couche 20 en matériau diélectrique. La couche 20 s'étend elle-même horizontalement directement sur la couche 3, du côté de cette couche 3 opposé au substrat 44.

L'épaisseur de la couche 20 est typiquement comprise entre 0,5 nm et 20 nm et, de préférence, entre 5 nm et 20 nm ou entre 1 nm et 10 nm. Ici, l'épaisseur de la couche 20 est égale à 6 nm.

La couche 36 comprend typiquement une sous-couche inférieure dopée 30, un empilement 34 de puits quantiques ou boites quantiques en quaternaire et une sous-couche supérieure 32 dopée avec un dopant de signe opposé à celui de la sous-couche 30. Les sous-couches 30 et 32 sont par exemple ici en InP dopées N ou P. Dans ce cas, l'empilement 34 est, par exemple, un empilement en alternance de sous-couches en InGaAsP ou en GaInNAs ou autre.

Sur la figure 1, seule une bande 33, un empilement 233 et une bande 234 réalisés, respectivement, dans la sous-couche 30, l'empilement 34 et la sous-couche 32 sont représentés. Cette superposition de la bande 33, de l'empilement 233 et de la bande 234 constitue le guide d'onde 200.

Le guide d'onde 200 comporte également :
- des prises 243G et 243D de contact en contact mécanique et électrique directement avec la bande 33 et situées, respectivement, à gauche et à droite de l'empilement 233, et
- une prise 244 de contact en contact mécanique et électrique directement avec la bande 234.

Ces prises 243G, 243D et 244 permettent d'injecter un courant électrique dans le guide d'onde 200 en matériau à gain III-V entre les prises 243G, 243D et la prise 244.

Le guide d'onde 220 est en silicium et réalisé dans le silicium monocristallin de la couche 3. Ce guide d'onde 220 s'étend sous la bande 33. Dans la figure 1, le guide d'onde 220 est représenté, à titre d'illustration, dans le cas particulier où la direction de propagation du signal optique à l'intérieur de ce guide d'onde est parallèle à la direction Y. Par exemple, à cet effet, le guide d'onde 220 adopte une configuration connue sous le terme anglais de « strip ». Ainsi, la section transversale de ce guide d'onde, parallèlement au plan XZ, présente un renflement central 222 à partir duquel s'étendent de chaque côté, parallèlement à la direction X, des bras latéraux 223G et 223D plus fins. Ici, le guide d'onde 220 est uniquement séparé de la bande 33 par une portion de la couche 20. Par exemple, le guide d'onde 220 est raccordé optiquement au guide d'onde 200 par un couplage adiabatique ou évanescent. Pour une description détaillée d'un couplage adiabatique le lecteur peut se référer à l'article suivant : Amnon Yariv et al., « Supermode Si/III-V hybrid Lasers, optical amplifiers and modulators: proposai and analysis » Optics Express 9147, vol. 14, No. 15, 23/07/2007.

Les caractéristiques du couplage optique entre le guide d'onde 220 et le guide d'onde 200 dépendent notamment des dimensions du guide d'onde 220 et, en particulier, de l'épaisseur du renflement central 222. Il est donc important que l'épaisseur de ce renflement 222 puisse être ajustée indépendamment des dimensions des autres composants photoniques réalisés sur le même substrat 44. Par exemple, ici, l'épaisseur du renflement 222 est égale à l'épaisseur maximale du silicium monocristallin dans la couche 3, c'est-à-dire dans cet exemple à 300 nm ou 500 nm.

Pour moduler la phase ou l'amplitude du signal optique, le système 6 comporte au moins un modulateur des perte de propagation et de l'indice de propagation d'un signal optique guidé et, souvent, au moins un dispositif d'accord de phase. Par exemple, le système 6 est un interféromètre de Mach-Zehnder dans lequel le modulateur et le dispositif d'accord de phase sont agencés dans l'une des branches de cet interféromètre pour moduler l'amplitude et/ou la phase du signal optique généré par la source laser 7. La structure d'un interféromètre de Mach-Zehnder est bien connue et n'est pas décrite ici en détail. Par conséquent, pour simplifier la figure 1, seul un modulateur 100 et un dispositif d'accord de phase 300 sont représentés en coupe verticale parallèlement au plan XZ.

Le dispositif 300 permet d'ajuster la phase d'un signal optique se propageant parallèlement à la direction Y à l'intérieur d'un guide d'onde 320. Par exemple, le guide d'onde 320 est plus long dans la direction Y que large dans la direction X. Le guide d'onde 320 est en silicium et réalisé dans le silicium monocristallin de la couche 3. Ici, son épaisseur est par exemple égale à l'épaisseur du renflement 222. L'indice de réfraction du silicium varie fortement en fonction de la température. Ainsi, en faisant varier la température du guide d'onde 320, on peut modifier la vitesse de propagation du signal optique dans ce guide d'onde et donc ajuster la phase du signal optique. A cet effet, le dispositif 300 comporte deux chaufferettes 322G et 322D disposées chacune d'un côté respectif du guide d'onde 320. Ici, la chaufferette 322D se déduit de la chaufferette 322G par symétrie orthogonale par rapport à un plan vertical parallèle aux directions Y et Z et passant par le milieu du guide d'onde 320. Ainsi, seule la chaufferette 322G va maintenant être décrite plus en détail en référence aux figures 1 et 2.

La chaufferette 322G comporte un bras 324 qui s'étend, parallèlement à la direction X, depuis une extrémité proximale 56 jusqu'à une extrémité distale 58. Le bras 324 s'étend également parallèlement à la direction Y. Le bras 324 est réalisé en silicium. Ici, il est réalisé dans le silicium monocristallin de la couche 3.

L'extrémité proximale 56 est directement en contact mécanique avec le guide d'onde 320. Par exemple, ici, l'extrémité proximale 56 touche un flanc vertical du guide d'onde 320. A cet effet, le bras 324 et le guide d'onde 320 ne forme qu'un seul bloc de matière.

Ici, l'épaisseur de l'extrémité proximale 56 est inférieure à l'épaisseur maximale du guide d'onde 320 de manière à confiner le signal optique dans le guide d'onde 320. Par exemple, l'épaisseur de l'extrémité proximale 56 est 1,5 fois ou deux fois ou trois fois ou quatre fois plus petite que l'épaisseur maximale du guide d'onde 320.

L'extrémité distale 58 est dopée pour rendre résistif le silicium monocristallin et former une résistance électrique qui ne forme qu'un seul bloc de matière avec le guide d'onde 320. Sur la figure 1, les régions dopées du silicium monocristallin sont finement hachurées et apparaissent en foncé. Dans ce mode de réalisation, l'extrémité proximale 56 est également dopée de la même manière que l'extrémité distale 58 de sorte que l'ensemble du bras 324 est ici réalisé en silicium monocristallin dopé. La distance la plus courte entre cette région dopée du bras 324 et le guide d'onde 320 est, par exemple, strictement supérieure à 200 nm ou 400 nm.

Pour faire circuler un courant électrique à l'intérieur de l'extrémité distale 58, la chaufferette 322G comporte aussi deux prises de contact 51G et 52G en contact mécanique et électrique directement avec l'extrémité distale 58. Ici, ces prises 51G et 52G sont situées l'une derrière l'autre dans la direction Y et à chaque bout de l'extrémité distale 58 dans cette direction Y. Les prises de contact de la chaufferette 322D, visibles sur la figure 2, portent, respectivement, les références 51D et 52D.

Lorsqu'un courant, amené par les prises 51G et 52G, traverse l'extrémité distale 58, celle-ci transforme une partie de l'énergie électrique ainsi reçue en chaleur qui se propage, par conduction thermique à travers l'extrémité proximale 56, jusqu'au guide d'onde 320. Ainsi, la chaufferette 322G permet de chauffer le guide d'onde 320 sans qu'aucun élément résistif ne soit implanté dans le guide d'onde 320 ou à proximité immédiate de ce guide d'onde. On limite ainsi les pertes de puissance du signal optique par rapport au cas où la résistance électrique est obtenue en dopant directement le guide d'onde 320. Le dispositif 300 permet donc d'ajuster lentement la phase du signal optique dans le guide d'onde 320. Par contre, il ne permet pas de faire varier rapidement la phase du signal optique.

A l'inverse, le modulateur 100 permet de modifier rapidement la phase du signal optique. A cet effet, il comporte deux électrodes 120 et 130. Ces électrodes 120 et 130 sont également visibles, en vue de dessus, sur la figure 2.

L'électrode 120 est en silicium monocristallin dopé. Elle est réalisée dans le silicium monocristallin de la couche 3. Elle s'étend, dans la direction X, depuis une extrémité proximale 12 jusqu'à une extrémité distale 11. Elle s'étend également dans la direction Y.

Ici, l'extrémité distale 11 est plus dopée que l'extrémité proximale 12. Par exemple, la concentration de dopant dans l'extrémité distale 11 est comprise entre 10¹⁸ et 2 x 10¹⁹ atomes/cm³. La concentration de dopant dans l'extrémité proximale 12 est par exemple comprise entre 10¹⁷ et 2 x 10¹⁸ atomes/cm³.

L'électrode 130 est réalisée en matériau cristallin III-V dopé avec un dopage de signe opposé à celui de l'électrode 120. Ici, elle est réalisée en InP dans la sous-couche 30. La concentration en dopant de l'électrode 130 est comprise, par exemple, entre 10¹⁷ et 2 x 10¹⁸ atomes/cm³ ou entre 10¹⁷ et 2 x 10¹⁹ atomes/cm³.

L'électrode 130 s'étend, parallèlement à la direction X, depuis une extrémité proximale 32 jusqu'à une extrémité distale 31. L'électrode 130 s'étend également dans la direction Y. Elle est directement située sur la couche 20.

L'extrémité proximale 32 est située en vis-à-vis de l'extrémité proximale 12 et séparée de cette extrémité proximale 12 uniquement par une portion de la couche 20 interposée entre ces extrémités proximales. Par rapport à un plan vertical parallèle aux directions Y et Z et passant par les extrémités proximales 12 et 32, l'extrémité distale 31 est située d'un côté de ce plan tandis que l'extrémité distale 11 est située de l'autre côté. Les extrémités distales 11 et 31 ne sont donc pas en vis-à-vis.

Dans le mode de réalisation de la figure 1 et les suivants, la zone 34, qui s'étend verticalement depuis l'extrémité distale 31 jusqu'au substrat 44, comporte uniquement des matériaux diélectriques solides. Ici, il s'agit des matériaux diélectriques 116 et de la couche 20. Grâce à cela, la capacité parasite entre cette extrémité 31 et le substrat 44 est fortement réduite. Plus précisément, la zone 34 est délimitée horizontalement :
- en haut, par un plan horizontal situé au niveau de l'interface entre l'électrode 130 et la couche 20, et
- en bas, par un plan horizontal situé au niveau de l'interface entre la couche 3 et le substrat 44.
La zone 34 est délimitée verticalement par un bord vertical virtuel qui en fait le tour complet. Ce bord vertical est conformé de manière à ce que la projection orthogonale de la zone 34 dans un plan horizontal est confondue avec la projection orthogonale de l'extrémité distale 31 dans ce même plan horizontal. La projection orthogonale de l'extrémité distale 31 dans ce plan horizontal correspond à la projection orthogonale de l'électrode 130 dans ce plan horizontal à laquelle est soustraite la projection orthogonale de l'extrémité proximale 32 dans le même plan. La projection orthogonale de l'extrémité proximale 32 dans ce plan est égale à l'intersection des projections orthogonales des électrodes 130 et 120 dans ce plan horizontal. Dans le cas particulier où les sections horizontales des électrodes 130 et 120 sont rectangulaires, comme représenté sur la figure 2, la zone 34 est donc délimitée verticalement :
- à gauche, par un plan vertical parallèle aux directions Y et Z et qui passe par un flanc vertical de l'extrémité distale 31 parallèle aux directions Y et Z,
- à droite, par un plan vertical parallèle aux directions Y et Z et qui passe par un flanc vertical de l'extrémité proximale 12 parallèle aux directions Y et Z,
- vers l'avant, par un plan vertical parallèle aux directions X et Z et qui passe par un flanc avant vertical de l'extrémité distale 31 parallèle aux directions X et Z, et
- vers l'arrière, par un plan vertical parallèle aux directions X et Z et qui passe par un flanc arrière vertical de l'extrémité distale 31 parallèle aux directions X et Z.
Sur la figure 1, la zone 34 a été mise en évidence en la remplissant avec des cercles. Toutefois, ici, il n'existe pas de discontinuité entre les matériaux diélectriques situés à l'intérieur de la zone 34 et ceux situés à l'extérieur de cette zone 34. C'est pour cette raison que le bord vertical décrit ci-dessus a été qualifié de « virtuel ».

La superposition, dans la direction Z, de l'extrémité proximale 12, d'une portion de la couche 20 et de l'extrémité proximale 32 est dimensionnée pour former un guide d'onde 70, capable de guider, dans la direction Y, le signal optique généré par la source laser 7. Les guides d'onde 70 et 320 sont par exemple raccordés optiquement l'un à l'autre par un coupleur adiabatique.

L'épaisseur maximale des extrémités proximales 12 et 32 est choisie pour que le point M, où se situe le maximum d'intensité du champ optique du signal optique qui se propage dans le guide d'onde 70, soit le plus près possible de la couche 20 et, de préférence, situé au centre de la portion de cette couche 20 interposée entre les électrodes proximales 12 et 32. En effet, c'est au niveau des interfaces entre les extrémités proximales 12, 32 et la couche 20 que la densité de porteurs de charges est maximale lorsqu'une différence de potentiels est présente entre ces extrémités proximales. Ainsi, en plaçant le point M à cet endroit, l'efficacité du modulateur 100 est améliorée. Dans ce mode de réalisation, les indices de réfraction des extrémités proximales 12 et 32 sont proches l'un de l'autre. Par conséquent, les épaisseurs maximales des extrémités proximales 12 et 32 sont choisies sensiblement égales pour que le point M soit situé à l'intérieur de la couche 20. Par exemple, l'épaisseur maximale e₁₂ de l'extrémité proximale 12 est comprise entre 0,5e₃₂ et 1,5e₃₂, et, de préférence, entre 0,7e₃₂ et 1,3e₃₂, où e₃₂ est l'épaisseur maximale de l'extrémité proximale 32. Par exemple, ici, les épaisseurs e₁₂ et e₃₂ sont choisies égales chacune à 300 nm.

Le modulateur 100 comporte aussi deux prises de contact 21 et 22, en contact mécanique et électrique directement avec, respectivement, les extrémités distales 11 et 30. Ces prises 21 et 22 sont raccordées à une source de tension commandable en fonction du bit ou des bits d'information à transmettre par le transmetteur 5.

Un fonctionnement possible du transmetteur 5 est le suivant. La source laser 7 génère un signal optique. Au moins, une partie de ce signal optique est dirigée vers un interféromètre de Mach Zehnder dont au moins l'une des branches comporte successivement le modulateur 100 et le dispositif d'accord de phase 300. Cette partie de signal optique est donc successivement guidée par le guide d'onde 70 puis le guide d'onde 320 avant d'être recombinée avec une autre partie du signal optique guidée par l'autre branche de l'interféromètre de Mach Zehnder pour former le signal optique modulé. Par exemple, les guides d'ondes 70 et 320 sont optiquement couplés l'un à l'autre par un coupleur adiabatique.

Un procédé de fabrication du transmetteur 100 va maintenant être décrit en référence aux figures 3 à 15. Les figures 4 à 15 représentent différents états de fabrication du transmetteur 5 en coupe verticale parallèlement aux directions X et Z.

Lors d'une étape 500, le procédé débute par la fourniture d'un substrat 4. Ici, ce substrat 4 est un substrat SOI (« silicon on insulator »). Le substrat 4 comporte directement empilés les uns au-dessus des autres dans la direction Z :
- un support 1 en silicium, , d'épaisseur supérieur à 400 µm ou 700 µm classiquement,
- une couche 2 enterrée en dioxyde de silicium, et
- une couche 43 en silicium monocristallin qui, à ce stade, n'a pas encore été gravée ni encapsulée dans un matériau diélectrique.

L'épaisseur de la couche 2 est, par exemple, supérieure à 35 nm ou 50 nm, voire même supérieure à 500 nm ou 1 µm. L'épaisseur de la couche 2 est généralement inférieure à 10 µm ou 20 µm. De préférence, pour la mise en oeuvre du procédé de la figure 3, l'épaisseur de la couche 2 est inférieure à 100 nm ou 70 nm.

Lors d'une étape 502, on procède à un dopage localisé de la couche 43. Ici, on procède d'abord à une première opération 504 de dopage localisée, lors de laquelle des régions dopées 506 (figure 5) de même dopage sont réalisées dans la couche 43. Ces régions 506 sont uniquement réalisées aux emplacements des futurs bras du dispositif d'accord 300 et de l'électrode 120 du modulateur 100. Ces régions 506 présentent un dopage égal à celui de l'extrémité distale 58 et de l'extrémité proximale 12.

Ensuite, une seconde opération 508 de dopage de la couche 43 est réalisée de manière à obtenir une région 510 (figure 6) plus fortement dopée que les régions 506. La région 510 est ici partiellement superposée à l'une des régions 506. Par exemple, la région 510 est obtenue en appliquant une nouvelle implantation sur une partie d'une des régions 506. La région 510 est réalisée à l'emplacement de la future extrémité distale 11 de l'électrode 120. Le dopage de la région 510 est ici égal au dopage de l'extrémité distale 11.

Lors d'une étape 514, la couche 43 subit une première gravure localisée partielle (figure 7) pour amincir l'épaisseur du silicium aux emplacements de l'électrode 120 et des bras 324 des chaufferettes 322G et 322D. A l'issue de l'étape 514, les régions 506 et 510 sont amincies et présentent une épaisseur inférieure à l'épaisseur initiale de la couche 43. Ici, l'épaisseur des régions 506 et 510 amincie est égale à l'épaisseur de l'électrode 120 et des bras 324.

Lors de cette étape 514, l'épaisseur de la couche 43 est également amincie dans des régions non dopées, par exemple, pour former les motifs du futur coupleur surfacique 8 et les bras latéraux 223G et 223D du guide d'onde 220. A l'inverse, lors de cette étape 514, d'autres régions dite « non-amincies », ne sont pas gravées et conservent leur épaisseur initiale. En particulier, ces régions non-amincies sont situées à l'emplacement du renflement 222 du guide d'onde 220 et à l'emplacement du guide d'onde 320.

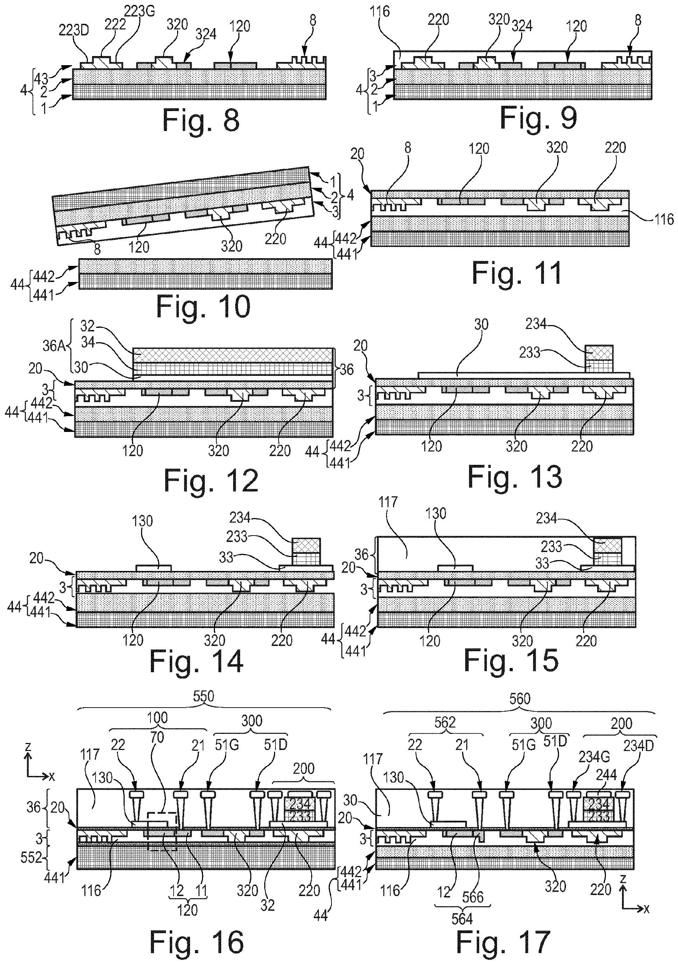

Lors d'une étape 516, une gravure totale localisée de la couche 43 est réalisée (figure 8). Contrairement à la gravure partielle, la gravure totale élimine complètement l'épaisseur de silicium de la couche 43 dans les régions non masquées où elle est appliquée. A l'inverse, des régions masquées protègent la couche 43 de cette gravure totale. Cette gravure totale est réalisée de manière à structurer, simultanément dans la couche 43, les guides d'onde 220 et 320, les bras du dispositif d'accord 300, le coupleur surfacique 8 et l'électrode 120. A cet effet, seules les régions correspondant à ces différents éléments sont masquées. On obtient à l'issue de cette étape, l'état représenté sur la figure 8.

Lors d'une étape 518, la couche 43 de silicium monocristallin, qui a été structurée lors des étapes précédentes, est encapsulée dans du dioxyde de silicium (figure 9). On obtient alors la couche 3 comportant du silicium monocristallin encapsulé dans le matériau diélectrique 116. La face supérieure du matériau 116 est ensuite préparée pour un collage, par exemple direct ou moléculaire. Par exemple, la face supérieure du matériau 116 est polie à l'aide d'un procédé tel qu'un procédé de CMP (Chemical-Mechanical Polishing) .

Lors d'une étape 520, la face supérieure du substrat 4, c'est-à-dire à ce stade la face polie du matériau 116, est ensuite collée sur la face extérieure du substrat 44 (figure 10), par exemple, par collage moléculaire. Le substrat 44 a déjà été décrit en référence à la figure 1.

Lors d'une étape 522, le support 1 est retiré, et la couche 2 est partiellement amincie pour ne laisser qu'une fine couche de dioxyde de silicium sur la couche 3. Ainsi, ici, la couche 20 est réalisée en retirant une partie seulement de la couche 2 en matériau diélectrique de manière à laisser subsister une fine couche de ce matériau diélectrique qui recouvre la couche 3 et forme ainsi la couche 20 (figure 11). On obtient ainsi, à l'issue de cette étape, un empilement du substrat 44 et des couches 3 et 20.

Lors d'une étape 524, une couche 36A (figure 12) en matériau à gain III-V est réalisée sur la couche 20. Par exemple, la couche 36A est collée sur la couche 20 au-dessus du guide d'onde 220 et de l'électrode 120. La couche 36A comporte la sous-couche 30 en InP dopée avec un dopage de signe opposé à celui de l'électrode 120, l'empilement 34 et la sous-couche 32.

Lors d'une étape 526, une gravure totale localisée (figure 13) de la sous-couche 32 et de l'empilement 34 est réalisée pour structurer la bande 234 dans la sous-couche 32 et l'empilement 233 dans l'empilement 34. Lors de cette étape, la sous-couche 30 n'est pas gravée.

Lors d'une étape 528, une gravure totale localisée (figure 14) de la sous-couche 30 est réalisée pour structurer simultanément la bande 33 et l'électrode 130 dans cette sous-couche.

Lors d'une étape 530, la couche 36A structurée est encapsulée (figure 15) dans le matériau diélectrique 117. On obtient alors la couche 36 comportant le matériau à gain III-V encapsulé dans le matériau diélectrique 117.

Enfin, lors d'une étape 532, les prises de contact 21, 22, 51G, 52G, 51D, 52D, 243G et 243D sont réalisées. On obtient alors le transmetteur 5 tel que représenté sur la figure 1.

Ce procédé de fabrication présente de nombreux avantages. En particulier :
- Il permet de contrôler précisément l'épaisseur de la couche 20 et d'obtenir une couche 20 particulièrement plane car elle est réalisée du coté de la couche 3 qui a le même niveau partout, ce qui simplifie le collage de la couche 36A.
- Il permet de régler précisément l'épaisseur de l'électrode 120 indépendamment de l'épaisseur du guide d'onde 220 et, plus généralement, indépendamment de l'épaisseur de la couche 43 en silicium monocristallin. Ceci est particulièrement utile car, généralement, pour améliorer le fonctionnement de la source laser 7, il faut que l'épaisseur du guide d'onde 220 soit assez grande, c'est-à-dire ici de l'ordre de 500 nm et que l'épaisseur de la bande 33 soit assez fine, c'est-à-dire ici de l'ordre de 300 nm ou 150 nm. A l'inverse, pour améliorer le fonctionnement du modulateur 100, comme expliqué ci-dessus, l'épaisseur de l'électrode 120 et, en particulier de son extrémité proximale 12, doit être choisie en fonction de l'épaisseur de l'extrémité proximale 32. Ici, l'épaisseur de l'extrémité proximale 32 est imposée par l'épaisseur de la sous-couche 30 en InP cristallin. Elle est donc de 300 nm ou 150nm.
- Ce procédé ne complexifie pas la fabrication du transmetteur 5. Par exemple, il permet de réaliser en une seule et même opération de gravure, la bande 33 du guide d'onde 200 et l'électrode 130 du modulateur 100. De même, l'électrode 120 et le guide d'onde 220 sont fabriqués simultanément lors de la même opération de gravure.
- Ce procédé permet d'éviter la formation d'une capacité parasite sous l'extrémité distale 31 et donc un fonctionnement plus rapide du modulateur 100.

La figure 16 représente un transmetteur 550 identique au transmetteur 5 sauf que le substrat 44 est remplacé par un substrat 552. Le substrat 552 est identique au substrat 44 sauf que la couche 442 est omise. Le procédé de fabrication du transmetteur 550 est, par exemple, le même que celui décrit pour le transmetteur 5 sauf que lors de l'étape 520, c'est le substrat 552 qui est utilisé à la place du substrat 44.

La figure 17 représente un transmetteur 560 identique au transmetteur 5 sauf que le modulateur 100 est remplacé par un modulateur 562. Le modulateur 562 est identique au modulateur 100 sauf que l'électrode 120 est remplacée par une électrode 564. L'électrode 564 est identique à l'électrode 120 sauf que l'extrémité distale 11 est remplacée par une extrémité distale 566. L'extrémité distale 566 est identique à l'extrémité distale 11 sauf que son épaisseur maximale est ici supérieure à l'épaisseur de l'extrémité proximale 12. Ici, l'épaisseur de l'extrémité distale 566 est égale à l'épaisseur maximale du guide d'onde 220 et donc de la couche 43 en silicium monocristallin.

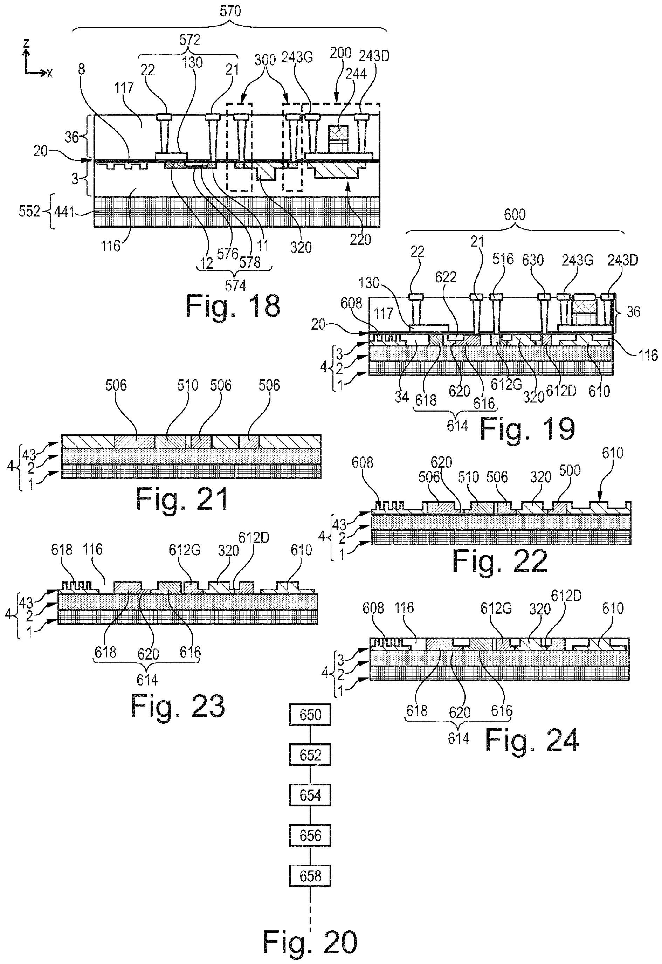

La figure 18 représente un transmetteur 570 identique au transmetteur 550 sauf que le modulateur 100 est remplacé par un modulateur 572. Le modulateur 572 est identique au modulateur 100 sauf que l'électrode 120 est remplacée par une électrode 574.

L'électrode 574 est identique à l'électrode 120 sauf que l'extrémité proximale 12 et l'extrémité distale 11 sont mécaniquement et électriquement accordées l'une à l'autre par une partie intermédiaire 576 dont l'épaisseur e₅₇₆ est strictement inférieure à l'épaisseur maximale de l'extrémité proximale 12. La partie intermédiaire 576 est séparée de la couche 20 par un renfoncement 578 remplit d'un matériau diélectrique. Ici le renfoncement 578 est remplit du matériau 116. Le fond de ce renfoncement est essentiellement horizontal et espacé de la couche 20 par une profondeur p₅₇₈. La profondeur p₅₇₈ est typiquement supérieure à 50 nm ou 100 nm. Ici, la profondeur p₅₇₈ est égale à 150 nm. Cette conformation de l'électrode 574 permet un meilleur contrôle de la largeur du guide d'onde 70. En effet, dans ce mode de réalisation, la largeur du guide d'onde 70 est uniquement fixée par la largeur W de l'extrémité proximale 12 dans la direction X. En effet, les portions de l'électrode 130 qui dépassent, dans la direction X, de l'extrémité proximale 12 sont isolées de l'électrode 574 par le renfoncement 578. Cette largeur W est, par gravure, définie à +/- δ près, où δ est une erreur égale, typiquement, à +/- 5 nm , ou +/-10 nm. Cette conformation de l'électrode 574 permet donc d'être moins sensible aux erreurs de positionnement de l'électrode 130. En effet, ce positionnement se fait par alignement lithographique, avec une précision δal typiquement égale à +/-30nm, ou +/-100nm. En absence du renfoncement 578, la largeur W du guide d'onde 70 est définie par la largeur du recouvrement des électrodes 130 et 120 et donc avec une erreur de +/- δal. Par ailleurs, le mode de réalisation de la figure 18 permet un meilleur contrôle de la capacité du modulateur. Par exemple, il a été calculé que l'erreur sur la capacité du modulateur 572 est de l'ordre de 1,6 % alors qu'en absence du renfoncement 578, cette erreur serait proche de 25 %.

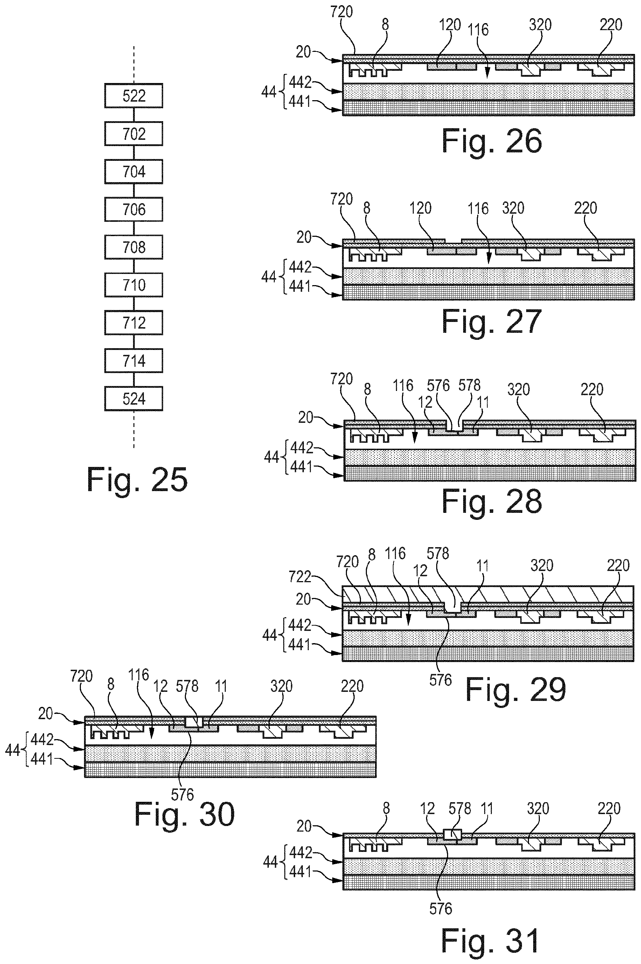

L'épaisseur e₅₇₆ est choisie de manière à empêcher ou à limiter la propagation du signal optique dans l'extrémité distale 11. Ici, cette épaisseur e₅₇₆ est aussi inférieure à l'épaisseur de l'extrémité proximale 12. Par exemple, l'épaisseur e₅₇₆ est inférieure ou égale à 0,5 x e₁₂, où e₁₂ est l'épaisseur maximale de l'extrémité proximale 12. Ici, l'épaisseur e₅₇₆ est égale à 150 nm et l'épaisseur e₁₂ est égale à 300 nm. Par exemple, la partie 576 est réalisée comme décrit en référence au procédé de la figure 25.

La figure 19 représente un transmetteur 600 identique au transmetteur 5 sauf que :
- le guide d'onde 220 est remplacé par un guide d'onde de 610,
- le coupleur surfacique 8 est remplacé par un coupleur surfacique 608,
- les bras du dispositif d'accord sont remplacés par des bras 612G et 612D, et
- l'électrode 120 est remplacée par une électrode 614.

L'électrode 614 comporte :
- une extrémité proximale 618 en vis-à-vis de l'extrémité proximale 32 de l'électrode 130,
- une extrémité distale 616 mécaniquement et électriquement directement raccordée à la prise 21, et
- une partie intermédiaire 620 qui relie mécaniquement et électriquement les extrémités 616 et 618.

Contrairement au mode de réalisation précédent, l'épaisseur de l'extrémité proximale 618 est ici égale à l'épaisseur maximale du guide d'onde 610. Cette épaisseur est donc égale ici à l'épaisseur maximale de la couche 43 en silicium monocristallin. Ce mode de réalisation présente toujours l'avantage de présenter sous l'extrémité distale 31 de l'électrode 130, la zone 34 uniquement constituée de matériau diélectrique solide. Ainsi, le modulateur du transmetteur 600 présente uniquement une capacité parasite négligeable à cet emplacement et son fonctionnement est donc plus rapide que le modulateur décrit dans la demande US2015/0055910.

Dans ce mode de réalisation, l'épaisseur de l'extrémité distale 616 est égale à l'épaisseur de l'extrémité proximale 618. L'épaisseur de la partie intermédiaire 620 est par contre strictement inférieure et, de préférence deux fois inférieure, à l'épaisseur de l'extrémité proximale 618 pour empêcher la propagation du signal optique dans l'extrémité distale 616. Comme dans le mode de réalisation de la figure 18, la partie intermédiaire 620 est séparée de la couche 20 par un renfoncement 622 remplit du matériau 116. La partie intermédiaire 620 et le renfoncement 622 sont conformés comme décrit pour la partie intermédiaire 576 et pour le renfoncement 578 de manière à conserver les avantages du mode de réalisation de la figure 18.

Un procédé de fabrication du transmetteur 600 va maintenant être décrit en référence aux figures 20 à 24.

Le procédé débute par des étapes 650 et 652 identiques, respectivement, aux étapes 500 et 502. On obtient alors l'état présenté sur la figure 21 qui est identique à l'état représenté sur la figure 6 sauf que les régions dopées 506 et 510 ne sont pas exactement situées aux mêmes emplacements.

Lors d'une étape 654, la couche 43 subit une gravure partielle localisée (figure 22) telle que celle décrite en référence à l'étape 514 pour amincir le silicium monocristallin à l'emplacement de la future partie intermédiaire 620. Cette gravure partielle localisée est aussi utilisée pour amincir, en même temps, le silicium monocristallin aux emplacements des futurs bras 612G et 612D, des bras latéraux du guide d'onde 610 et du coupleur surfacique 608.

Lors d'une étape 656, la couche 43 subit une gravure totale localisée (figure 23) pour structurer simultanément dans le silicium monocristallin, l'électrode 614, le coupleur surfacique 608, les bras 612G et 612D et le guide d'onde 610. Cette étape est réalisée, par exemple, comme décrit pour l'étape 516.

Lors d'une étape 658 (figure 24), le silicium monocristallin est encapsulé dans du dioxyde de silicium. On obtient ainsi la couche 3 de silicium monocristallin encapsulé dans le matériau diélectrique 116. La face supérieure du matériau 116 est alors préparée pour un collage direct. Cette étape est similaire à l'étape 518 précédemment décrite.

Ensuite, la fabrication du transmetteur 600 se poursuit par les étapes 524 à 532 du procédé de la figure 3. Pour simplifier la figure 20, ces étapes suivantes n'ont pas été représentées.

La figure 25 représente un procédé de fabrication du transmetteur 570. Ce procédé est identique à celui de la figure 3 sauf qu'il comporte des étapes supplémentaires 702 à 714 introduites entre les étapes 522 et 524 du procédé de la figure 3. Pour simplifier la figure 25, les étapes avant l'étape 522 et après l'étape 524 n'ont pas été représentées.

Lors de l'étape 702 (figure 26), une couche 720 de nitrure de silicium est directement déposée sur la couche 20.

Lors de l'étape 704 (figure 27), la couche 720 est complètement éliminée seulement en face de l'endroit où le renfoncement 578 doit être creusé dans l'électrode 120. La couche 720 forme ainsi à partir de ce stade un masque de gravure.

Lors de l'étape 706 (figure 28), l'électrode 120 est partiellement gravée à travers le masque de gravure formé par la couche 720 pour réaliser le renfoncement 578 et la partie intermédiaire 576 de l'électrode 120.

Lors de l'étape 708 (figure 29), une couche 722 en matériau diélectrique tel que de l'oxyde de silicium, est directement déposée sur la face supérieure de la couche 720. Cette couche 722 remplit alors complètement le renfoncement 578.

Lors de l'étape 710 (figure 30), on procède à une planarisation, c'est-à-dire à un polissage de la face supérieure en utilisant la couche 720 comme couche d'arrêt. Par exemple, ce polissage est un polissage physico-chimique (« Chemical Mechanicla Planarization »). À la fin de cette étape, la face supérieure de la couche 720 est mise à nu et directement exposée à l'extérieur. Le renfoncement 578 reste quant à lui rempli par le matériau diélectrique.

Lors de l'étape 712 (figure 31), la couche 720 est complètement éliminée pour mettre à nu la face supérieure de la couche 20.

Lors de l'étape 714, la face mise à nu de la couche 20 est polie et préparée pour le collage de la couche 36A lors de l'étape 524.

De nombreux autres modes de réalisation sont possibles. Par exemple, le modulateur 100 peut aussi être un modulateur en anneau. A cet effet, le guide d'onde 70 se referme sur lui-même pour former un guide d'onde annulaire dans lequel la densité des porteurs de charge peut être modifiée en fonction de la différence de potentiels appliquée entre les prises 21 et 22. Typiquement, ce guide d'onde annulaire est raccordé à un guide d'onde dans lequel se propage le signal optique à moduler par un couplage évanescent. Dans ce cas, le dispositif d'accord 300 de phase peut être omis. Le guide d'onde 70 peut aussi constituer uniquement une portion limitée du guide d'onde annulaire.

Dans un autre mode de réalisation, le modulateur est utilisé pour moduler l'intensité du signal optique qui le traverse. En effet, une modification de la densité des porteurs de charge dans le guide d'onde 70 modifie également l'intensité du signal optique qui le traverse.

En variante, seule l'extrémité proximale 12 est amincie et l'extrémité distale 11 ne l'est pas. Ainsi, dans ce mode de réalisation, par exemple, l'épaisseur de l'extrémité 11 est égale à l'épaisseur de la couche 43 en silicium monocristallin. En effet, pour centrer le point M, où se situe le maximum de l'intensité du champ optique du signal optique, au centre de la couche 20, c'est l'épaisseur des extrémités 12 et 32 qui est importante. L'épaisseur des extrémités distales 11 et 31 n'a pas d'importance notable sur ce point.

Dans une variante, le dopage de l'extrémité proximale 12 et de l'extrémité distale 11 sont les mêmes. Dès lors, lors de la fabrication de l'électrode 120, l'une des deux étapes de dopage de la couche 43 en silicium monocristallin peut être omise.

D'autres matériaux diélectriques sont possibles pour le matériau 116 et la couche 20. Par exemple, il peut s'agir de nitrure de silicium, de nitrure d'Aluminium, d'un polymère électriquement isolant, de Al₂O₃. De plus, dans le cas de la couche 20, son indice de réfraction n'est pas nécessairement inférieur à celui du silicium.

Dans une autre variante, la couche 20 est totalement éliminée là où elle n'est pas indispensable au fonctionnement du transmetteur. Par exemple, elle est totalement éliminée sauf entre les extrémités proximales 12 et 32 et entre le guide d'onde 220 et la bande 33. Dans une autre variante, la couche 20 est aussi éliminée entre le guide d'onde 220 et la bande 33.

D'autres matériaux à gain III-V sont possibles pour réaliser la couche 36. Par exemple, la couche 36 est formée de l'empilement suivant en allant du bas vers le haut :
- une sous-couche inférieure en GaAs dopée N,
- des sous-couches à boites quantiques en AIGaAs , ou des puits quantiques AIGaAs, et
- une sous-couche supérieure en GaAs dopée P.

Le matériau III-V utilisé pour réaliser la sous-couche 30 peut être différent. Par exemple, il peut s'agir de AsGa dopée N ou P. On notera aussi que l'InP dopé P présente plus de perte optique que l'InP dopé N, et qu'il est donc préférable d'utiliser au niveau du modulateur pour l'électrode 130 de l'InP dopé N

Dans un autre mode de réalisation, l'électrode 130 est réalisée dans un matériau III-V différent de celui utilisé pour réaliser la bande 33. Dans ce cas, l'électrode 130 et la bande 33 ne sont pas structurées dans une même sous-couche en matériau III-V.

Quel que soit le mode de réalisation, il est possible d'intervertir les régions dopées N et P.

En variante, une partie ou la totalité des prises de contact sont réalisées, non pas à travers le matériau 117, mais à travers le substrat 4, 44 ou 552. Dans ce cas, par rapport à ce qui a été représenté sur les figures précédentes, une ou plusieurs prises de contact électrique émergent sous le substrat.

En variante, les guides d'ondes 70, 220, 320, 610 sont incurvés. Dans ce cas, la conformation des différents éléments optiquement couplés à ces guides d'onde est adaptée au rayon de courbure de ces guides d'onde.

Le guide d'onde 220 peut prendre une configuration dite « en bande » c'est-à-dire que les bras latéraux 223G et 223D sont omis ou tout autre configuration capable de guider un signal optique.

En variante, la chaufferette à 322D est omise. Dans une autre variante, l'épaisseur de l'extrémité distale 58 est strictement supérieure à l'épaisseur de l'extrémité proximale 56. Par exemple, l'épaisseur de l'extrémité distale 58 est égale à l'épaisseur maximale du guide d'onde 320.

Le dopage de l'extrémité proximale 56 peut être différent de celui de l'extrémité distale 58. Par exemple, le dopage de l'extrémité proximale 56 peut être égal à celui de l'extrémité distale 11 ou différent. Dans une autre variante, l'extrémité proximale 56 n'est pas dopée.

D'autres procédés de fabrication sont possibles. Par exemple, la couche isolante 20 peut être obtenue par des procédés de fabrication différents. Par exemple, l'étape 522 est remplacée par une étape lors de laquelle la couche 2 est complètement retirée jusqu'à la couche 3 puis la couche 20 est déposée sur la couche 3 mise à nue. Dans ce cas, éventuellement, la couche 20 peut être réalisée dans un matériau diélectrique différent du matériau 116 tel qu'un polymère électriquement isolant ou en Al₂O₃. Après le retrait complet de la couche 2, il est aussi possible de réaliser la couche 20 par oxydation de la surface de la couche 3 ou par oxydation de la sous-couche 30 en matériau III-V avant son collage directement sur la couche 3.

Dans une autre variante, la deuxième gravure totale localisée est remplacée par une gravure uniforme de toute la surface de la couche 3 pour transformer les régions non-amincies en régions amincies et éliminer complètement les régions amincies.

Les différents modes de réalisation du dispositif d'accord de phase décrit ci-dessus peuvent être mis en oeuvre indépendamment des différents modes de réalisation du modulateur. En particulier, le dispositif d'accord de phase peut être utilisé dans tout système photonique où il est nécessaire d'accorder la phase d'un signal optique qui se propage dans un guide d'onde en silicium et peu importe que ce système comporte un modulateur tel que celui revendiqué ici. Par exemple, le dispositif d'accord peut aussi être mis en oeuvre dans un système photonique utilisant un modulateur comme celui décrit dans la demande US2015/0055910. Il peut aussi être utilisé dans un système photonique ne comportant aucun modulateur.

La présence de la partie intermédiaire 576 ou 620 peut être mise en oeuvre indépendamment de la présence d'une source laser et/ou d'un dispositif d'accord sur le même substrat. Elle peut aussi être appliquée quels que soient les matériaux utilisés pour fabriquer les électrodes du modulateur. Une telle partie intermédiaire peut aussi bien être ménagée dans les deux électrodes que dans une seule de ces électrodes. L'électrode dans laquelle est ménagée la partie intermédiaire peut aussi bien être l'électrode située sous la couche 20 que sur la couche 20. L'épaisseur de la partie intermédiaire doit être inférieure à l'épaisseur de l'extrémité proximale. Par contre, son épaisseur n'est pas nécessairement aussi inférieure à l'épaisseur de l'extrémité distale. Par exemple, son épaisseur peut être égale à l'épaisseur de l'extrémité distale. Par exemple, une partie intermédiaire, telle que la partie 576 ou 620, peut avantageusement être introduite dans les modes de réalisations d'un modulateur décrits dans les demandes US2009103850, WO2011/037686, US2015/0055910, US6845198B2 et autres.

## Revendications

1. Transmetteur photonique comportant :
- un empilement comportant un substrat (1,2 ; 44 ; 552) s'étendant principalement dans un plan appelé « plan du substrat » et une couche (3), comportant du silicium monocristallin, s'étendant directement sur ce substrat et principalement parallèlement au plan du substrat,
- une source laser (7) à semi-conducteur apte à générer un signal optique, cette source laser comportant un premier guide d'onde (200) en matériau III-V gravé dans une couche en matériau à gain III-V, cette couche en matériau à gain III-V comportant une sous-couche (30) en matériau cristallin III-V dopé,
- un modulateur (100 ; 562; 572) des pertes de propagation et de l'indice de propagation d'un signal optique guidé réalisé sur le même substrat (1, 2 ; 44 ; 552) et apte à moduler le signal optique généré par la source laser à semi-conducteur, ce modulateur comportant :
• une première électrode (120 ; 564 ; 574 ; 614) en silicium monocristallin dopé P ou N structurée dans le silicium monocristallin de la couche (3) comportant du silicium monocristallin,
• une seconde électrode (130) en matériau cristallin III-V dopé présentant un dopage de signe opposé à celui de la première électrode,
**caractérisé en ce que** :
- la couche (3) comportant du silicium monocristallin est une couche comportant du silicium monocristallin encapsulé dans un matériau diélectrique, (20,34,116)
- l'empilement comporte une couche (20) en matériau diélectrique s'étendant directement sur la couche (3) comportant du silicium monocristallin,
- la sous-couche (30) en matériau cristallin III-V dopé s'étend directement sur la couche (20) en matériau diélectrique,
- la première électrode du modulateur s'étend, dans une direction transversale (X) parallèle au plan du substrat, depuis une extrémité proximale (12 ; 618) jusqu'à une extrémité distale (11 ; 566 ; 616), et s'étendant longitudinalement dans la direction (Y) de propagation du signal optique,
- la seconde électrode du modulateur s'étendant, dans la direction transversale (X), depuis une extrémité proximale (32) située en vis-à-vis de l'extrémité proximale (12 ; 618) de la première électrode (120 ; 564 ; 574 ; 614) jusqu'à une extrémité distale (31) située d'un côté opposé à l'extrémité distale (11 ; 566 ; 616) de la première électrode (120 ; 564 ; 574 ; 614) par rapport à un axe perpendiculaire au plan du substrat et traversant les extrémités proximales (12 ; 618 ; 32), cette seconde électrode (130) s'étendant longitudinalement également dans la direction (Y) de propagation du signal optique,
- la couche (20) en matériau diélectrique est interposée entre les extrémités proximales (12 ; 618, 32) des première et seconde électrodes du modulateur pour les isoler électriquement l'une de l'autre,
- le modulateur comporte également :
• un premier guide d'onde (70) apte à guider le signal optique à moduler dans la direction (Y) de propagation du signal optique, ce premier guide d'onde étant formé par les extrémités proximales (12 ; 618, 32) des électrodes et la portion de la couche (20) en matériau diélectrique interposée entre ces extrémités proximales (12 ; 618, 32),
• des prises de contact (21, 22) directement en contact mécanique et électrique avec, respectivement, les extrémités distales (11 ; 566 ; 616, 31) des électrodes (120 ; 564 ; 574 ; 614, 130) pour raccorder électriquement les première et seconde électrodes à des potentiels électriques différents de manière à modifier la densité de porteurs de charges à l'intérieur du premier guide d'onde (70),
• une zone (34) uniquement composée d'un ou plusieurs matériaux diélectriques solides (20, 116) qui s'étend :
- dans la direction perpendiculaire au plan du substrat, depuis l'extrémité distale (31) de la seconde électrode jusqu'au substrat (1, 2 ; 44 ; 552), et
- dans la direction transversale (X) et dans la direction (Y) de propagation du signal optique, sous la totalité de l'extrémité distale (31) de la seconde électrode (130).

2. Transmetteur selon la revendication 1, dans lequel la seconde électrode (130) de ce modulateur est gravée dans la sous-couche (30) en matériau cristallin III-V dopé s'étendant directement sur la couche (20) en matériau diélectrique.

3. Transmetteur selon l'une quelconque des revendications précédentes, dans lequel :
- la source laser à semi-conducteur comporte un deuxième guide d'onde (220 ; 610) réalisé dans le silicium monocristallin de la couche (3) comportant du silicium monocristallin et situé sous le premier guide d'onde (200) en matériau III-V, ce deuxième guide d'onde étant raccordé optiquement au premier guide d'onde (200) en matériau III-V par un couplage évanescent ou adiabatique, et
- l'épaisseur maximale de l'extrémité proximale (12) de la première électrode (120 ; 564 ; 574) est différente de l'épaisseur maximale du deuxième guide d'onde (220; 610).

4. Transmetteur selon la revendication 3, dans lequel l'épaisseur maximale de l'extrémité proximale (12) de la première électrode (120 ; 564 ; 574) est strictement inférieure à l'épaisseur maximale du deuxième guide d'onde (220 ; 610).

5. Transmetteur selon la revendication 4, dans lequel l'épaisseur maximale de l'extrémité proximale (12) de la première électrode (120 ; 564 ; 574) est comprise entre 0,7e₃₂ et 1,3e₃₂, où e₃₂ est l'épaisseur maximale de l'extrémité proximale (32) de la seconde électrode (130).

6. Transmetteur selon l'une quelconque des revendications précédentes, dans lequel l'extrémité proximale (12 ; 618) et l'extrémité distale (11 ; 616) sont mécaniquement et électriquement accordées l'une à l'autre par une partie intermédiaire (576 ; 620) dont l'épaisseur est strictement inférieure à l'épaisseur maximale de l'extrémité proximale (12 ; 618).

7. Transmetteur selon la revendication 6, dans lequel la partie intermédiaire (576 ; 620) est séparée de la couche (20) en matériau diélectrique par un renfoncement (578, 622) remplit d'un matériau diélectrique.

8. Transmetteur selon l'une quelconque des revendications précédentes, dans lequel la seconde électrode est réalisée en InP ou en AsGa.

9. Transmetteur selon l'une quelconque des revendications précédentes, dans lequel le transmetteur comporte également :
- un troisième guide d'onde (320) apte à guider le signal optique généré par la source laser et réalisé dans le silicium monocristallin de la couche (3) comportant du silicium monocristallin,
- un dispositif d'accord (300) de la phase du signal optique qui se propage dans ce troisième guide d'onde (320), ce dispositif d'accord (300) comportant :
• un bras (324 ; 612G, 612D) réalisé dans le silicium monocristallin de la couche (3) comportant du silicium monocristallin et qui s'étend, dans une direction transversale (X) parallèle au plan du substrat et perpendiculaire à la direction (Y) de propagation du signal optique dans le troisième guide d'onde (320), depuis une extrémité proximale (56) directement en contact mécanique avec le troisième guide d'onde (320), jusqu'à une extrémité distale (58) dopée N ou P, l'épaisseur minimale de l'extrémité proximale de ce bras dans une direction perpendiculaire au plan du substrat étant strictement inférieure à l'épaisseur maximale du troisième guide d'onde dans la même direction, ce bras s'étendant également dans la direction de propagation du signal optique dans le troisième guide d'onde (320)
• des prises de contact (51G, 52G, 51D, 52D) directement en contact mécanique et électrique avec l'extrémité distale (58) pour faire circuler un courant dans cette extrémité distale apte à chauffer le guide d'onde par conduction thermique à travers le bras (324 ; 612G, 612D).

10. Procédé de fabrication d'un transmetteur photonique à semi-conducteur conforme à l'une quelconque des revendications précédentes, ce procédé comporte :
- la fourniture (500) d'un premier empilement comportant successivement un premier support (1), une couche (2) enterrée en matériau diélectrique et une couche (43) en silicium monocristallin, puis
- le dopage localisé (502) de la couche (43) en silicium monocristallin de manière à obtenir une première région de la couche en silicium monocristallin dopée,
- une première gravure localisée partielle (514) de l'épaisseur de la couche (43) en silicium monocristallin de manière à amincir l'épaisseur de la couche (43) en silicium monocristallin au moins dans la première région dopée et ainsi obtenir une première région dopée amincie, tout en laissant l'épaisseur de la couche (43) en silicium monocristallin inchangée dans d'autres régions dites « non-amincies »,
- une deuxième gravure totale localisée (516) de la couche (43) en silicium monocristallin qui élimine totalement l'épaisseur de la couche (43) en silicium monocristallin dans les régions gravées lors de cette deuxième gravure et laisse l'épaisseur de la couche (43) en silicium monocristallin inchangée dans des régions masquées où cette deuxième gravure n'est pas appliquée, les régions gravées et masquées lors de cette deuxième gravure étant agencées les unes par rapport aux autres pour structurer simultanément :
- le deuxième guide d'onde (220) en silicium monocristallin dans une région non-amincie de la couche (43) en silicium monocristallin,
- la première électrode (120 ; 564 ; 574) du modulateur, l'extrémité proximale (12) de la première électrode (120 ; 564 ; 574) étant réalisée dans la première région dopée amincie, l'extrémité proximale (12) de la première électrode (120 ; 564 ; 574) ayant alors une épaisseur strictement inférieure à l'épaisseur du deuxième guide d'onde, puis
- l'encapsulation (518) de la couche (43) en silicium monocristallin structurée, dans un matériau diélectrique (116) pour obtenir une couche (3) de silicium monocristallin encapsulé dans un matériau diélectrique, puis
- le collage (520) d'un second substrat (44 ; 552) sur la couche (3) de silicium monocristallin encapsulé, puis
- le retrait (522) du premier support (1) et de tout ou partie de la couche (2) enterrée et la réalisation de la couche (20) en matériau diélectrique sur la couche (3) en silicium monocristallin encapsulé du côté où le premier support (1) a été retiré, puis
- la réalisation (524) de la couche (36) en matériau à gain III-V directement sur la couche (20) en matériau diélectrique.

11. Procédé selon la revendication 10, dans lequel la fourniture d'un premier empilement comporte la fourniture d'un premier empilement dans lequel l'épaisseur de la couche enterrée en matériau diélectrique est inférieure à 100 nm ou 70 nm.

12. Procédé selon la revendication 10 ou 11, dans lequel le procédé comporte une étape de gravure de la sous-couche (30) en matériau cristallin III-V dopé pour réaliser simultanément la seconde électrode (130) du modulateur et une bande (33) du guide d'onde (200) en matériau III-V dans cette sous-couche (30) en matériau cristallin III-V.

13. Procédé selon l'une quelconque des revendications 10 à 12, dans lequel :
- lors du dopage localisé (502) de la couche (43) en silicium monocristallin, une seconde région, adjacente à la première région, est dopée moins fortement que la première région, et
- lors de la deuxième gravure (516), les régions gravées et masquées sont agencées les unes par rapport aux autres pour réaliser l'extrémité distale (11 ; 566) de la première électrode (120 ; 564 ; 574) dans la seconde région dopée.

14. Procédé selon l'une quelconque des revendications 10à 13, dans lequel :
- le dopage localisé (502) de la première couche (43) en silicium monocristallin est réalisé de manière à obtenir, en plus de la première région dopée, une région dopée supplémentaire dans la couche (43) en silicium monocristallin,
- la première gravure localisée partielle (514) est réalisée de manière à obtenir, en plus de la première région dopée amincie, au moins une région amincie supplémentaire dans la couche (43) en silicium monocristallin,
- lors de la deuxième gravure totale localisée (516), les régions gravées et masquées sont agencées pour structurer simultanément, en plus du deuxième guide d'onde (220) et de la première électrode (120 ; 564 ; 574 ; 614) :
- un troisième guide d'onde (320) en silicium monocristallin dans une région non-amincie de la couche (43) en silicium monocristallin, et
- un bras (324) qui s'étend, dans une direction transversale parallèle au plan du substrat et perpendiculaire à la direction de propagation du signal optique dans le troisième guide d'onde (320), depuis une extrémité proximale (56) directement en contact mécanique avec le troisième guide d'onde (320), jusqu'à une extrémité distale (58), l'extrémité distale (58) étant réalisée dans la région dopée supplémentaire de la couche (43) en silicium monocristallin et l'extrémité proximale (56) étant réalisée dans la région amincie supplémentaire de la couche (43) en silicium monocristallin de sorte que l'épaisseur minimale de l'extrémité proximale (56) de ce bras dans une direction perpendiculaire au plan du substrat est strictement inférieure à l'épaisseur maximale du troisième guide d'onde (320) dans la même direction, ce bras s'étendant également dans la direction de propagation du signal optique dans le troisième guide d'onde (320), puis
- la réalisation (532) de prises de contact (51G, 52G, 51D, 52D) directement en contact mécanique et électrique avec l'extrémité distale (58) du bras (324) pour faire circuler un courant dans cette extrémité distale et ainsi chauffer le bras.

## Patentansprüche

1. Photonischer Sender, aufweisend:
- einen Stapel, aufweisend ein Substrat (1,2; 44; 552), das sich im Wesentlichen in einer als "Ebene des Substrats" bezeichneten Ebene erstreckt, und eine Schicht (3), die einkristallines Silicium enthält, die sich direkt über diesem Substrat und im Wesentlichen parallel zur Ebene des Substrats erstreckt,
- eine Halbleiter-Laserquelle (7), die ein optisches Signal erzeugen kann, wobei die Laserquelle einen ersten Wellenleiter (200) aus III-V-Material aufweist, der in eine Schicht aus III-V-Verstärkungsmaterial geätzt ist, wobei diese III-V-Verstärkungsmaterialschicht eine Unterschicht (30) aus kristallinem dotiertem III-V-Material aufweist,
- einen Modulator (100; 562; 572) der Ausbreitungs- und Ausbreitungsindexverluste eines geführten optischen Signals, das in dem gleichen Substrat (1, 2; 44; 552) erzeugt wird und der das von der Halbleiter-Laserquelle produzierte optische Signal modulieren kann, wobei dieser Modulator aufweist:
• eine erste Elektrode (120; 564; 574; 614) aus p- oder n-dotiertem einkristallinem Silicium, strukturiert in dem einkristallinen Silicium der Schicht (3), die einkristallines Silicium aufweist,
• eine zweite Elektrode (130) aus kristallinem dotiertem III-V-Material mit einer entgegengesetzten Dotierung wie die der ersten Elektrode,
**dadurch gekennzeichnet, dass**:
- die Schicht (3), die einkristallines Silicium aufweist, eine Schicht ist, die in ein dielektrisches Material (20, 34, 116) eingekapseltes einkristallines Silicium aufweist,
- der Stapel eine Schicht (20) aus dielektrischem Material aufweist, die sich direkt auf der Schicht (3), die einkristallines Silicium aufweist, erstreckt,
- die Unterschicht (30) aus kristallinem dotiertem III-V-Material sich direkt auf der Schicht (20) aus dielektrischem Material erstreckt,
- sich die erste Elektrode des Modulators in einer Querrichtung (X) parallel zur Ebene des Substrats von einem proximalen Ende (12; 618) bis zu einem distalen Ende (11; 566; 616) erstreckt, und sich längs in der Richtung (Y) der Ausbreitung des optischen Signals erstreckt,
- sich die zweite Elektrode des Modulators in der Querrichtung (X) von einem proximalen Ende (32), das gegenüber dem proximalen Ende (12; 618) der ersten Elektrode (120; 564; 574; 614) liegt, bis zu einem distalen Ende (31), das auf einer gegenüberliegenden Seite des distalen Endes (11; 566; 616) der ersten Elektrode (120; 564; 574; 614) liegt, in Bezug auf eine Achse erstreckt, die senkrecht zur Ebene des Substrats ist und die proximalen Enden (12; 618; 32) durchquert, wobei sich diese zweite Elektrode (130) längs ebenfalls in der Ausbreitungsrichtung (Y) des optischen Signals erstreckt,
- die Schicht (20) aus dielektrischem Material zwischen den proximalen Enden (12; 618, 32) der ersten und zweiten Elektroden des Modulators angeordnet ist, um sie elektrisch voneinander zu isolieren,
- der Modulator auch aufweist:
• einen ersten Wellenleiter (70), der das zu modulierende optische Signal in der Ausbreitungsrichtung (Y) des optischen Signals führen kann, wobei dieser erste Wellenleiter durch die proximalen Enden (12; 618, 32) der Elektroden und den Abschnitt der Schicht (20) aus dielektrischem Material gebildet ist, der zwischen diesen proximalen Enden (12; 618, 32) angeordnet ist,
• Kontaktanschlüsse (21, 22), die direkt in mechanischem oder elektrischem Kontakt mit jeweils den distalen Enden (11; 566; 616, 31) der Elektroden (120; 564; 574; 614, 130) stehen, um die ersten und zweiten Elektroden elektrisch mit verschiedenen elektrischen Potentialen zu verbinden, um die Ladungsträgerdichte innerhalb des ersten Wellenleiters (70) zu modifizieren,
• eine Zone (34), die nur aus einem oder mehreren festen dielektrischen Materialien (20, 116) besteht, die sich erstreckt:
- in der Richtung senkrecht zur Ebene des Substrats von dem distalen Ende (31) der zweiten Elektrode bis zu dem Substrat (1, 2; 44; 552), und
- in der Querrichtung (X) und in der Ausbreitungsrichtung (Y) des optischen Signals unter der Gesamtheit des distalen Endes (31) der zweiten Elektrode (130).

2. Sender nach Anspruch 1, wobei die zweite Elektrode (130) dieses Modulators in die Unterschicht (30) aus kristallinem dotiertem III-V-Material geätzt ist, die sich direkt auf der Schicht (20) aus dielektrischem Material erstreckt.

3. Sender nach einem der vorhergehenden Ansprüche, wobei:
- die Halbleiter-Laserquelle einen zweiten Wellenleiter (220; 610) aufweist, der in dem einkristallinen Silicium der Schicht (3), die einkristallines Silicium aufweist, erzeugt wird und unter dem ersten Wellenleiter (200) aus III-V-Material liegt, wobei dieser zweite Wellenleiter mit dem ersten Wellenleiter (200) aus III-V-Material optisch durch adiabatische oder evaneszente Kopplung verbunden ist, und
- die maximale Dicke des proximalen Endes (12) der ersten Elektrode (120; 564; 574) von der maximalen Dicke des zweiten Wellenleiters (220; 610) verschieden ist.

4. Sender nach Anspruch 3, wobei die maximale Dicke des proximalen Endes (12) der ersten Elektrode (120; 564; 574) strikt kleiner ist als die maximale Dicke des zweiten Wellenleiters (220; 610).

5. Sender nach Anspruch 4, wobei die maximale Dicke des proximalen Endes (12) der ersten Elektrode (120; 564; 574) im Bereich zwischen 0,7e₃₂ und 1,3e₃₂ liegt, wobei e₃₂ die maximale Dicke des proximalen Endes (32) der zweiten Elektrode (130) ist.

6. Sender nach einem der vorhergehenden Ansprüche, wobei das proximale Ende (12; 618) und das distale Ende (11; 616) über einen Zwischenabschnitt (576; 620) mechanisch und elektrisch miteinander verbunden sind, dessen Dicke strikt kleiner ist als die maximale Dicke des proximalen Endes (12; 618).

7. Sender nach Anspruch 6, wobei der Zwischenabschnitt (576; 620) von der Schicht (20) aus dielektrischem Material durch eine Vertiefung (578, 622) getrennt ist, die mit einem dielektrischen Material gefüllt ist.

8. Sender nach einem der vorhergehenden Ansprüche, wobei die zweite Elektrode aus InP oder aus AsGa hergestellt ist.

9. Sender nach einem der vorhergehenden Ansprüche, wobei der Sender außerdem aufweist:
- einen dritten Wellenleiter (320) der das optische Signal führen kann, das von der Laserquelle produziert wird, und in dem einkristallinen Silicium der Schicht (3), die einkristallines Silicium aufweist, erzeugt wird,
- eine Vorrichtung zum Anpassen (300) der Phase des optischen Signals, das sich in diesem dritten Wellenleiter (320) ausbreitet, wobei diese Anpassungsvorrichtung (300) umfasst:
• einen Arm (324; 612G, 612D), der aus dem einkristallinen Silicium der Schicht (3), die einkristallines Silicium aufweist, erzeugt wird und der sich in einer Querrichtung (X) parallel zur Ebene des Substrats und senkrecht zur Ausbreitungsrichtung (Y) des optischen Signals in dem dritten Wellenleiter (320) von einem proximalen Ende (56), das direkt in mechanischem Kontakt mit dem dritten Wellenleiter (320) ist, bis zu einem n- oder p-dotierten distalen Ende (58) erstreckt, wobei die minimale Dicke des proximalen Endes dieses Arms in einer Richtung senkrecht zur Ebene des Substrats strikt kleiner ist als die maximale Dicke des dritten Wellenleiters in der gleichen Richtung, wobei sich dieser Arm ebenfalls in Ausbreitungsrichtung des optischen Signals in dem dritten Wellenleiter (320) erstreckt,
• Kontaktanschlüsse (51G, 52G, 51D, 52D), die mit dem distalen Ende (58) direkt in mechanischem und elektrischem Kontakt stehen, um einen Strom in diesem distalen Ende zirkulieren zu lassen, der den Wellenleiter durch Wärmeleitung durch den Arm (324; 612G, 612D) erwärmen kann.

10. Verfahren zur Herstellung eines photonischen Halbleiter-Senders nach einem der vorhergehenden Ansprüche, wobei das Verfahren aufweist:
- das Bereitstellen (500) eines ersten Stapels, der nacheinander einen ersten Träger (1), eine vergrabene Schicht (2) aus dielektrischem Material und eine Schicht (43) aus einkristallinem Silicium aufweist, dann
- lokales Dotieren (502) der Schicht (43) aus einkristallinem Silicium, um eine erste dotierte Region der Schicht aus einkristallinem Silicium zu erhalten,
- ein erstes lokales, teilweises Ätzen (514) der Dicke der Schicht (43) aus einkristallinem Silicium, um die Dicke der Schicht (43) aus einkristallinem Silicium mindestens in der ersten dotierten Region dünner zu machen und so eine erste dünnere dotierte Region zu erhalten, während die Dicke der Schicht (43) aus einkristallinem Silicium in anderen Regionen, die als "nicht dünner gemacht" bezeichnet werden, unverändert bleibt,
- ein zweites vollständiges lokales Ätzen (516) der Schicht (43) aus einkristallinem Silicium, das die Dicke der Schicht (43) aus einkristallinem Silicium in den geätzten Regionen während dieses zweiten Ätzens vollständig entfernt und die Dicke der Schicht (43) aus einkristallinem Silicium in maskierten Regionen unverändert lässt, wobei dieses zweite Ätzen nicht angewendet wird, wenn die geätzten und maskierten Regionen während dieses zweiten Ätzens zueinander angeordnet sind, um gleichzeitig zu strukturieren:
- den zweiten Wellenleiter (220) aus einkristallinem Silicium in einer nicht dünner gemachten Region der Schicht (43) aus einkristallinem Silicium,
- die erste Elektrode (120; 564; 574) des Modulators, wobei das proximale Ende (12) der ersten Elektrode (120; 564; 574) in der ersten dünner gemachten dotierten Region erzeugt wird, wobei das proximale Ende (12) der ersten Elektrode (120; 564; 574) dann eine Dicke hat, die strikt kleiner ist als die Dicke des zweiten Wellenleiters, dann
- Einkapseln (518) der strukturierten Schicht (43) aus einkristallinem Silicium in einem dielektrischen Material (116), um eine Schicht (3) aus einkristallinem Silicium, eingekapselt in einem dielektrischen Material, zu erhalten, dann
- Kleben (520) eines zweiten Substrats (44; 552) auf die Schicht (3) aus eingekapseltem einkristallinem Silicium, dann
- Entfernen (522) des ersten Trägers (1) und der Gesamtheit oder eines Teils der vergrabenen Schicht (2) und Erzeugen der Schicht (20) aus dielektrischem Material auf der Schicht (3) aus eingekapseltem einkristallinem Silicium auf der Seite, auf der der erste Träger (1) entfernt wurde, dann
- Erzeugen (524) der Schicht (36) aus III-V-Verstärkungsmaterial direkt auf der Schicht (20) aus dielektrischem Material.

11. Verfahren nach Anspruch 10, wobei das Bereitstellen eines ersten Stapels das Bereitstellen eines ersten Stapels aufweist, in dem die Dicke der vergrabenen Schicht aus dielektrischem Material kleiner als 100 nm oder 70 nm ist.

12. Verfahren nach Anspruch 10 oder 11, wobei das Verfahren einen Schritt zum Ätzen der Unterschicht (30) aus kristallinem dotiertem III-V-Material aufweist, um gleichzeitig die zweite Elektrode (130) des Modulators und einen Streifen (33) des Wellenleiters (200) aus III-V-Material in dieser Unterschicht (30) aus kristallinem III-V-Material zu erzeugen.

13. Verfahren nach einem der Ansprüche 10 bis 12, wobei:
- während der lokalen Dotierung (502) der Schicht (43) aus einkristallinem Silicium eine zweite Region, die an die erste Region angrenzt, weniger stark dotiert wird als die erste Region, und
- während des zweiten Ätzens (516) die geätzten und maskierten Regionen zueinander angeordnet werden, um das distale Ende (11; 566) der ersten Elektrode (120; 564; 574) in der zweiten dotierten Region zu erzeugen.

14. Verfahren nach einem der Ansprüche 10 bis 13, wobei:
- das lokale Dotieren (502) der ersten Schicht (43) aus einkristallinem Silicium durchgeführt wird, um neben der ersten dotierten Region eine zusätzliche dotierte Region in der Schicht (43) aus einkristallinem Silicium zu erhalten,
- das teilweise lokale erste Ätzen (514) durchgeführt wird, um neben der ersten dotierten, dünner gemachten Region mindestens eine zusätzliche dünner gemachte Region in der Schicht (43) aus einkristallinem Silicium
- während des zweiten vollständigen lokalisierten Ätzen (516) zu erhalten, wobei die geätzten und maskierten Regionen angeordnet sind, um gleichzeitig, zusätzlich zu dem zweiten Wellenleiter (220) und der ersten Elektrode (120; 564; 574; 614) Folgendes zu strukturieren:
- einen dritten Wellenleiter (320) aus einkristallinem Silicium in einer nicht dünner gemachten Region der Schicht (43) aus einkristallinem Silicium, und
- einen Arm (324), der sich in einer Querrichtung parallel zur Ebene des Substrats und senkrecht zur Ausbreitungsrichtung des optischen Signals in dem dritten Wellenleiter (320) von einem proximalen Ende (56), das direkt in mechanischem Kontakt mit dem dritten Wellenleiter (320) ist, bis zu einem distalen Ende (58) erstreckt, wobei das distale Ende (58) in der zusätzlichen dotierten Region der Schicht (43) aus einkristallinem Silicium erzeugt wird und wobei das proximale Ende (56) in der zusätzlichen dünner gemachten Region der Schicht (43) aus einkristallinem Silicium erzeugt wird, so dass die minimale Dicke des proximalen Endes (56) dieses Arms in einer Richtung senkrecht zur Ebene des Substrats strikt kleiner ist als die maximale Dicke des dritten Wellenleiters (320) in der gleichen Richtung, wobei sich dieser Arm ebenfalls in Ausbreitungsrichtung des optischen Signals in dem dritten Wellenleiter (320) erstreckt, dann
- das Erzeugen (532) von Kontaktanschlüssen (51G, 52G, 51D, 52D), die direkt in mechanischem und elektrischem Kontakt mit dem distalen Ende (58) des Arms (324) stehen, um einen Strom in diesem distalen Ende zirkulieren zu lassen und so den Arm zu erwärmen.

## Claims

1. Photonic transmitter including:
- a stack including a substrate (1, 2; 44; 552) mainly extending in a plane called the "plane of the substrate" and a layer (3), including single-crystal silicon, extending directly over this substrate and mainly parallelly to the plane of the substrate,
- a semiconductor laser source (7) able to generate an optical signal, this laser source including a first waveguide (200) made of III-V material etched in a layer made of III-V gain material, this layer made of III-V gain material including a sublayer (30) made of doped III-V crystalline material,
- a modulator (100; 562; 572) of the propagation losses and of the propagation index of a guided optical signal produced in the same substrate (1, 2; 44; 552) and able to modulate the optical signal generated by the semiconductor laser source, this modulator including:
• a first electrode (120; 564; 574; 614) made of p- or n-doped single-crystal silicon structured in the single-crystal silicon of the layer (3) including single-crystal silicon,
• a second electrode (130) made of doped III-V crystalline material having a doping of opposite type to that of the first electrode,
**characterized in that**:
- the layer (3) including single-crystal silicon is a layer including single-crystal silicon encapsulated in a dielectric material (20, 34, 116),
- the stack includes a layer (20) made of dielectric material extending directly over the layer (3) including single-crystal silicon,
- the sublayer (30) made of doped III-V crystalline material extends directly over the layer (20) made of dielectric material,
- the first electrode of the modulator extends, in a transverse direction (X) parallel to the plane of the substrate, from a proximal end (12; 618) to a distal end (11; 566; 616), and extending longitudinally in the direction (Y) of propagation of the optical signal,
- the second electrode of the modulator extending, in the transverse direction (X), from a proximal end (32) located facing the proximal end (12; 618) of the first electrode (120; 564; 574; 614) to a distal end (31) located on a side that is opposite the distal end (11; 566; 616) of the first electrode (120; 564; 574; 614) with respect to an axis perpendicular to the plane of the substrate and passing through the proximal ends (12; 618; 32), this second electrode (130) also extending longitudinally in the direction (Y) of propagation of the optical signal,
- the layer (20) made of dielectric material is interposed between the proximal ends (12; 618, 32) of the first and second electrodes of the modulator in order to electrically insulate them from each other, and
- the modulator also includes:
• a first waveguide (70) able to guide the optical signal to be modulated in the direction (Y) of propagation of the optical signal, this first waveguide being formed by the proximal ends (12; 618, 32) of the electrodes and that segment of the layer (20) made of dielectric material which is interposed between these proximal ends (12; 618, 32),
• contacts (21, 22) making direct mechanical and electrical contact with, respectively, the distal ends (11; 566; 616, 31) of the electrodes (120; 564; 574; 614, 130), for electrically connecting the first and second electrodes to different electric potentials so as to modify the charge carrier density inside the first waveguide (70),
• a zone (34) composed only of one or more solid dielectric materials (20, 116), which extends:
- in the direction perpendicular to the plane of the substrate, from the distal end (31) of the second electrode to the substrate (1, 2; 44; 552), and
- in the transverse direction (X) and in the direction (Y) of propagation of the optical signal, under the entirety of the distal end (31) of the second electrode (130).

2. Transmitter according to Claim 1, wherein the second electrode (130) of this modulator is etched in the sublayer (30) made of doped III-V crystalline material extending directly over the layer (20) made of dielectric material.

3. Transmitter according to either one of the preceding claims, wherein:
- the semiconductor laser source includes a second waveguide (220; 610) produced in the single-crystal silicon of the layer (3) including single-crystal silicon and located under the first waveguide (200) made of III-V material, this second waveguide being optically connected to the first waveguide (200) made of III-V material by adiabatic or evanescent coupling, and
- the maximum thickness of the proximal end (12) of the first electrode (120; 564; 574) is different from the maximum thickness of the second waveguide (220; 610).

4. Transmitter according to Claim 3, wherein the maximum thickness of the proximal end (12) of the first electrode (120; 564; 574) is strictly smaller than the maximum thickness of the second waveguide (220; 610).

5. Transmitter according to Claim 4, wherein the maximum thickness of the proximal end (12) of the first electrode (120; 564; 574) is comprised between 0.7e32 and 1.3e32, where e₃₂ is the maximum thickness of the proximal end (32) of the second electrode (130)

6. Transmitter according to any one of the preceding claims, wherein the proximal end (12; 618) and the distal end (11; 616) are mechanically and electrically connected to one another by an intermediate portion (576; 620) the thickness of which is strictly smaller than the maximum thickness of the proximal end (12; 618).

7. Transmitter according to Claim 6, wherein the intermediate portion (576; 620) is separated from the layer (20) made of dielectric material by a recess (578, 622) filled with a dielectric material.

8. Transmitter according to any one of the preceding claims, wherein the second electrode is made from InP or from GaAs.

9. Transmitter according to any one of the preceding claims, wherein the transmitter also includes:
- a third waveguide (320) able to guide the optical signal generated by the laser source and produced in the single-crystal silicon of the layer (3) including single-crystal silicon,
- a device (300) for tuning the phase of the optical signal that propagates in this third waveguide (320), this tuning device (300) including:
• an arm (324; 612G, 612D) produced in the single-crystal silicon of the layer (3) including single-crystal silicon and that extends, in a transverse direction (X) parallel to the plane of the substrate and perpendicular to the direction (Y) of propagation of the optical signal in the third waveguide (320), from a proximal end (56) making direct mechanical contact with the third waveguide (320), to an n- or p-doped distal end (58), the minimum thickness of the proximal end of this arm in a direction perpendicular to the plane of the substrate being strictly smaller than the maximum thickness of the third waveguide in the same direction, this arm also extending in the direction of propagation of the optical signal in the third waveguide (320)
• contacts (51G, 52G, 51D, 52D) making direct mechanical and electrical contact with the distal end (58), for making a current able to heat the waveguide by thermal conduction through the arm (324; 612G, 612D) flow through this distal end.

10. Process for fabricating a semiconductor photonic transmitter according to any one of the preceding claims, this process includes:
- providing (500) a first stack including in succession a first carrier (1), a buried layer (2) made of dielectric material and a layer (43) made of single-crystal silicon, then
- locally doping (502) the layer (43) made of single-crystal silicon so as to obtain a first region of the layer made of single-crystal silicon that is doped,
- carrying out a partial localized first etch (514) of the thickness of the layer (43) made of single-crystal silicon so as to thin the thickness of the layer (43) made of single-crystal silicon at least in the first doped region and to thus obtain a first thinned doped region, while leaving the thickness of the layer (43) made of single-crystal silicon unchanged in other regions that are said to be "non-thinned",
- carrying out a second complete localized etch (516) of the layer (43) made of single-crystal silicon, which completely removes the thickness of the layer (43) made of single-crystal silicon in the regions etched during this second etch and leaves the thickness of the layer (43) made of single-crystal silicon unchanged in masked regions to which this second etch is not applied, the masked regions and the etched regions being arranged, during this second etch, with respect to one another, in order to simultaneously structure:
- the second waveguide (220) made of single-crystal silicon in a non-thinned portion of the layer (43) made of single-crystal silicon,
- the first electrode (120; 564; 574) of the modulator, the proximal end (12) of the first electrode (120; 564; 574) being produced in the first thinned doped region, the proximal end (12) of the first electrode (120; 564; 574) then having a thickness strictly smaller than the thickness of the second waveguide, then
- encapsulating (518) the layer (43) made of structured single-crystal silicon in a dielectric material (116) in order to obtain a layer (3) of single-crystal silicon encapsulated in a dielectric material, then
- bonding (520) a second substrate (44; 552) to the layer (3) of encapsulated single-crystal silicon, then
- removing (522) the first carrier (1) and all or some of the buried layer (2) and producing the layer (20) made of dielectric material on the layer (3) made of encapsulated single-crystal silicon on the side from which the first carrier (1) was removed, then
- producing (524) the layer (36) made of III-V gain material directly on the layer (20) made of dielectric material.

11. Process according to Claim 10, wherein the provision of a first stack includes providing a first stack in which the thickness of the buried layer made of dielectric material is smaller than 100 nm or 70 nm.

12. Process according to Claim 10 or 11, wherein the process includes a step of etching the sublayer (30) made of doped III-V crystalline material in order to simultaneously produce the second electrode (130) of the modulator and a strip (33) of the waveguide (200) made of III-V material in this sublayer (30) made of III-V crystalline material.

13. Process according to any one of Claims 10 to 12, wherein:
- during the localized doping (502) of the layer (43) made of single-crystal silicon, a second region, adjacent to the first region, is doped less strongly than the first region, and
- during the second etch (516), the masked regions and etched regions are arranged, with respect to one another, in order to produce the distal end (11; 566) of the first electrode (120; 564; 574) in the second doped region.

14. Process according to any one of Claims 10 to 13, wherein:
- the localized doping (502) of the first layer (43) made of single-crystal silicon is carried out so as to obtain, in addition to the first doped region, an additional doped region in the layer (43) made of single-crystal silicon,
- the partial localized first etch (514) is carried out so as to obtain, in addition to the first thinned doped region, at least one additional thinned region in the layer (43) made of single-crystal silicon,
- during the complete localized second etch (516), the masked regions and etched regions are arranged to simultaneously structure, in addition to the second waveguide (220) and the first electrode (120; 564; 574; 614):
- a third waveguide (320) made of single-crystal silicon in a non-thinned region of the layer (43) made of single-crystal silicon, and
- an arm (324) that extends, in a transverse direction parallel to the plane of the substrate and perpendicular to the direction of propagation of the optical signal in the third waveguide (320), from a proximal end (56) making direct mechanical contact with the third waveguide (320), to a distal end (58), the distal end (58) being produced in the additional doped region of the layer (43) made of single-crystal silicon and the proximal end (56) being produced in the additional thinned region of the layer (43) made of single-crystal silicon so that the minimum thickness of the proximal end (56) of this arm in a direction perpendicular to the plane of the substrate is strictly smaller than the maximum thickness of the third waveguide (320) in the same direction, this arm also extending in the direction of propagation of the optical signal in the third waveguide (320), then
- producing (532) contacts (51G, 52G, 51D, 52D) making direct mechanical and electrical contact with the distal end (58) of the arm (324), in order to make a current flow through this distal end and thus heat the arm.
